# EUROPEAN PATENT APPLICATION

(11) **EP 4 422 370 A2**
(43) Date of publication of application: **28.08.2024**
(21) Application number: 24157572.9
(22) Date of filing: 14.02.2024
(51) Int. Cl.: H10B 43/27, H10B 43/40, H10B 80/00

(54) **MEMORY DEVICE**

(30) Priority: 21.02.2023 KR 20230023148
(71) Applicant: Samsung Electronics Co., Ltd., Suwon-si, Gyeonggi-do 16677 (KR)
(72) Inventor: FUTATSUYAMA, Takuya, 16677 Suwon-si, Gyeonggi-do (KR); BYEON, Daeseok, 16677 Suwon-si, Gyeonggi-do (KR)
(74) Representative: Kuhnen & Wacker Patent- und Rechtsanwaltsbüro PartG mbB

(57) **Abstract**

A memory device is disclosed. The memory device includes a first cell region including first memory strings, a second cell region attached to the first cell region and including second memory strings, and a peripheral circuit region attached to the first cell region and including a peripheral circuit configured to control the first and second memory strings, the first cell region including a low-level bit line electrically connected to the first memory strings, a low-level bonding pad provided between the peripheral circuit region and the first cell region, a low-level connection via connected to the low-level bonding pad, a high-level bonding pad provided between the first and second cell regions, the second cell region including a high-level bit line electrically connected to the second memory strings, and a high-level connection via connected to the high-level bonding pad and being laterally offset from the low-level connection via.

## Description

### BACKGROUND

### 1. Field

The disclosure relates to a memory device, and more particularly, to a memory device having memory strings arranged in the vertical direction.

### 2. Description of Related Art

Recently, electronic devices and systems require a memory device capable of storing high-capacity data. One of ways to increase data storage capacity of a memory device is to include three-dimensionally arranged memory cells, instead of two-dimensionally arranged memory cells, in the memory devices. In addition, the memory device may include a first portion formed on a first substrate, a second portion formed on a second substrate, and the first substrate is bonded to the second substrate.

### SUMMARY

The disclosure provides a memory device having excellent operating characteristics and an improved degree of integration.

According to an aspect of the disclosure, there is provided a memory device including: a first cell region including a plurality of first memory strings connected to each other in a vertical direction; a second cell region coupled to the first cell region and including a plurality of second memory strings connected to each other in the vertical direction; and a peripheral circuit region coupled to the first cell region and including a peripheral circuit configured to control the plurality of first memory strings and the plurality of second memory strings, wherein the first cell region includes: a first bit line electrically connected to one or more of the plurality of first memory strings; a first bonding pad provided at a first bonding interface between the peripheral circuit region and the first cell region; a first connection via connected between the first bit line and the first bonding pad; and a second bonding pad provided at a second bonding interface between the first cell region and the second cell region, and the second cell region includes: a second bit line electrically connected to one or more of the plurality of second memory strings; and a second connection via connected between the second bit line and the second bonding pad, wherein the second connection via is offset with respect to the first connection via in a first horizontal direction, and wherein the first bit line and the second bit line are electrically connected to the peripheral circuit through the first connection via, the first bonding pad, the second connection via, and the second bonding pad.

According to another aspect of the disclosure, there is provided a memory device including: a first cell region including a plurality of first memory strings connected to each other in a vertical direction; a second cell region coupled to the first cell region and including a plurality of second memory strings connected to each other in the vertical direction; and a peripheral circuit region coupled to the first cell region and including a peripheral circuit configured to control the plurality of first memory strings and the plurality of second memory strings, wherein the first cell region includes: a first-level bit line electrically connected to one or more of the plurality of first memory strings, the first-level bit line extending in a first horizontal direction; a first-level bonding pad provided at a first bonding interface between the peripheral circuit region and the first cell region; a second-level bonding pad provided at a second bonding interface between the first cell region and the second cell region; a first-level connection via located between the first-level bit line and the first-level bonding pad; and a connection via structure located between the first-level bit line and the second-level bonding pad, the connection via structure extending in the vertical direction and overlapping the second-level bonding pad in the vertical direction, and the second cell region includes: a second-level bit line electrically connected to one or more of the plurality of second memory strings, the second-level bit line extending in the first horizontal direction; and a second-level connection via located between the second-level bit line and the second-level bonding pad, wherein the second-level connection via is offset with respect to the first-level connection via in the first horizontal direction, wherein the first-level bit line and the second-level bit line are electrically connected to the peripheral circuit through the first-level bonding pad, the first-level connection via, the connection via structure, the second-level bonding pad, and the second-level connection via.

According to another aspect of the disclosure, there is provided a memory device including: a first cell region including a plurality of first memory strings connected to each other in a vertical direction; a second cell region coupled to the first cell region and including a plurality of second memory strings connected to each other in the vertical direction; and a peripheral circuit region coupled to the first cell region and including a peripheral circuit configured to control the plurality of first memory strings and the plurality of second memory strings, wherein the first cell region includes: a first-level bit line electrically connected to one or more of the plurality of first memory strings; a plurality of first-level bonding pads provided at a first bonding interface between the peripheral circuit region and the first cell region; and a plurality of second-level bonding pads provided at a second bonding interface between the first cell region and the second cell region, wherein the plurality of second-level bonding pads are offset with respect to the plurality of first-level bonding pads in a first horizontal direction, and wherein the second cell region includes a second-level bit line electrically connected to one or more of the plurality of second memory strings and electrically connected to the plurality of second-level bonding pads, and wherein a first planar arrangement shape of the plurality of first-level bonding pads is different from a second planar arrangement shape of the plurality of second-level bonding pads.

### BRIEF DESCRIPTION OF DRAWINGS

Embodiments will be more clearly understood from the following detailed description taken in conjunction with the accompanying drawings in which:
FIG. 1 is a block diagram of a memory device according to an example embodiment;
FIG. 2 is a circuit diagram illustrating a memory block according to an example embodiment;
FIG. 3 schematically illustrates a structure of a memory device according to an example embodiment;
FIG. 4 is a diagram illustrating a memory device according to an example embodiment;
FIG. 5 is a diagram illustrating a memory device according to an example embodiment;
FIG. 6 is a plan view schematically illustrating the memory device of FIG. 5;
FIG. 7 is a diagram illustrating a memory device according to an example embodiment;
FIGS. 8A and 8B are plan layout diagrams of a memory device according to an example embodiment;
FIGS. 9A and 9B are plan layout diagrams of a memory device according to an example embodiment;
FIGS. 10A and 10B are schematic diagrams illustrating an example of an arrangement of bonding pads of the memory device illustrated in FIGS. 9A and 9B;
FIGS. 11 and 12 are cross-sectional views illustrating a memory device according to an example embodiment;
FIG. 13 is a schematic diagram illustrating a memory device according to an example embodiment;
FIGS. 14A and 14B are plan layout diagrams illustrating the memory device of FIG. 13;
FIGS. 15A and 15B are plan schematic diagrams illustrating a memory device according to an example embodiment;
FIGS. 16 and 17 are cross-sectional views illustrating a memory device according to an example embodiment;
FIG. 18 is a diagram illustrating a memory device according to an example embodiment;
FIG. 19 is a schematic cross-sectional view of the memory device of FIG. 18;
FIG. 20 is a cross-sectional view illustrating a memory device according to an example embodiment;
FIG. 21 is a cross-sectional view illustrating a memory device according to an example embodiment; and
FIG. 22 is a diagram illustrating a memory device according to an example embodiment.

### DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order. Also, descriptions of features that are known after an understanding of the disclosure of this application may be omitted for increased clarity and conciseness.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

Throughout the specification, in an example in which a component is described as being "connected to," or "coupled to" another component, it may be directly "connected to," or "coupled to" the other component, or there may be one or more other components intervening therebetween. In contrast, in an example in which an element is described as being "directly connected to," or "directly coupled to" another element, there can be no other elements intervening therebetween. Likewise, similar expressions, for example, "between" and "immediately between," and "adjacent to" and "immediately adjacent to," are also to be construed in the same way. As used herein, the term "and/or" includes any one and any combination of any two or more of the associated listed items.

Although terms such as "first," "second," and "third" may be used herein to describe various members, components, regions, layers, or sections, these members, components, regions, layers, or sections are not to be limited by these terms. Rather, these terms are only used to distinguish one member, component, region, layer, or section from another member, component, region, layer, or section. Thus, a first member, component, region, layer, or section referred to in examples described herein may also be referred to as a second member, component, region, layer, or section without departing from the teachings of the examples.

The terminology used herein is for describing various examples only and is not to be used to limit the disclosure. The articles "a," "an," and "the" are intended to include the plural forms as well, unless the context clearly indicates otherwise. The terms "comprises," "includes," and "has" specify the presence of stated features, numbers, operations, members, elements, and/or combinations thereof, but do not preclude the presence or addition of one or more other features, numbers, operations, members, elements, and/or combinations thereof.

Unless otherwise defined, all terms, including technical and scientific terms, used herein have the same meaning as commonly understood by one of ordinary skill in the art to which this disclosure pertains and based on an understanding of the disclosure of the present application. Terms, such as those defined in commonly used dictionaries, are to be interpreted as having a meaning that is consistent with their meaning in the context of the relevant art and the disclosure of the present application and are not to be interpreted in an idealized or overly formal sense unless expressly so defined herein. The use of the term "may" herein with respect to an example or embodiment (e.g., as to what an example or embodiment may include or implement) means that at least one example or embodiment exists where such a feature is included or implemented, while all example embodiments are not limited thereto.

The embodiments of the disclosure are example embodiments, and thus, the disclosure is not limited thereto and may be realized in various other forms. As is traditional in the field, embodiments may be described and illustrated in terms of blocks, as shown in the drawings, which carry out a described function or functions. These blocks, which may be referred to herein as units or modules or the like, or by names such as device, logic, circuit, counter, comparator, generator, converter, names ending in "~or" or the like, may be physically implemented by analog and/or digital circuits including one or more of a logic gate, an integrated circuit, a microprocessor, a microcontroller, a memory circuit, a passive electronic component, an active electronic component, an optical component, and the like, and may also be implemented by or driven by software and/or firmware (configured to perform the functions or operations described herein).

Hereinafter, embodiments are described in detail with reference to the accompanying drawings.

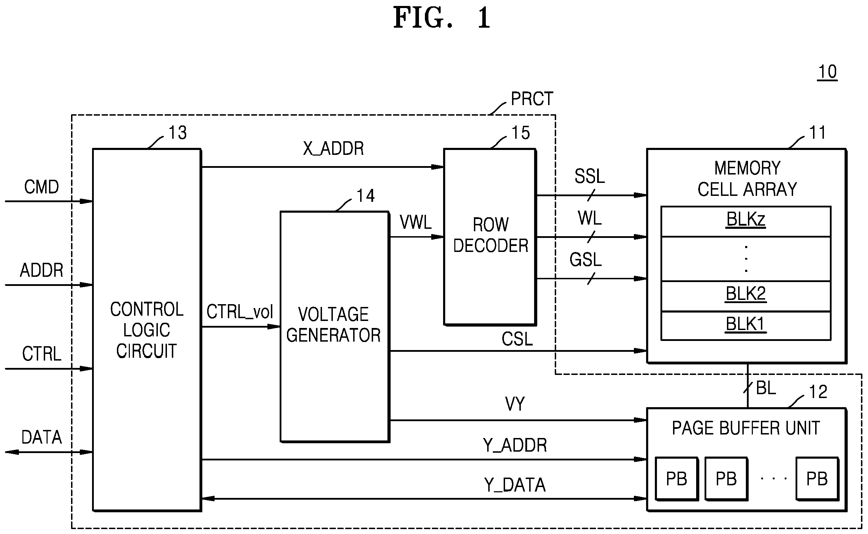

FIG. 1 is a block diagram of a memory device 10 according to an example embodiment.

Referring to FIG. 1, the memory device 10 may include a memory cell array 11 and a peripheral circuit PRCT. The peripheral circuit PRCT may include a page buffer unit 12, a control logic circuit 13, a voltage generator 14, and a row decoder 15. However, the disclosure is not limited to the components illustrated in FIG. 1, and as such, according to other example embodiments, one or more components may be added and/or omitted from the memory device 10. For example, the peripheral circuit PRCT may further include a data input/output (I/O) circuit or an I/O interface. Also, the peripheral circuit PRCT may further include a temperature sensor, a command decoder, an address decoder, and the like. In this specification, the memory device 10 may refer to a "nonvolatile memory device". However, the disclosure is not limited thereto, and as such, the one or more novel aspects of the disclosure may be implemented in various types of memory devices or storage devices.

The memory cell array 11 may include a plurality of memory blocks BLK1 to BLKz, where z is a positive integer. Also, each of the memory blocks BLK1 to BLKz may include a plurality of memory cells. The memory cell array 11 may be connected to the page buffer unit 12, the voltage generator 14, and the row decoder 15. The memory cell array 11 may be connected to the page buffer unit 12 through bit lines BL, may be connected to the voltage generator 14 through a common source line CSL, and may be connected to the row decoder 15 through word lines WL, string select lines SSL, and ground select lines GSL. For example, the memory cells may be flash memory cells. Hereinafter, embodiments are described in detail taking a case in which the memory cells are NAND flash memory cells, as an example. However, the disclosure is not limited thereto, and according to an embodiment, the memory cells may be resistive memory cells, such as resistive RAM (ReRAM) memory cells, phase change RAM (PRAM) memory cells, or magnetic RAM (MRAM) memory cells.

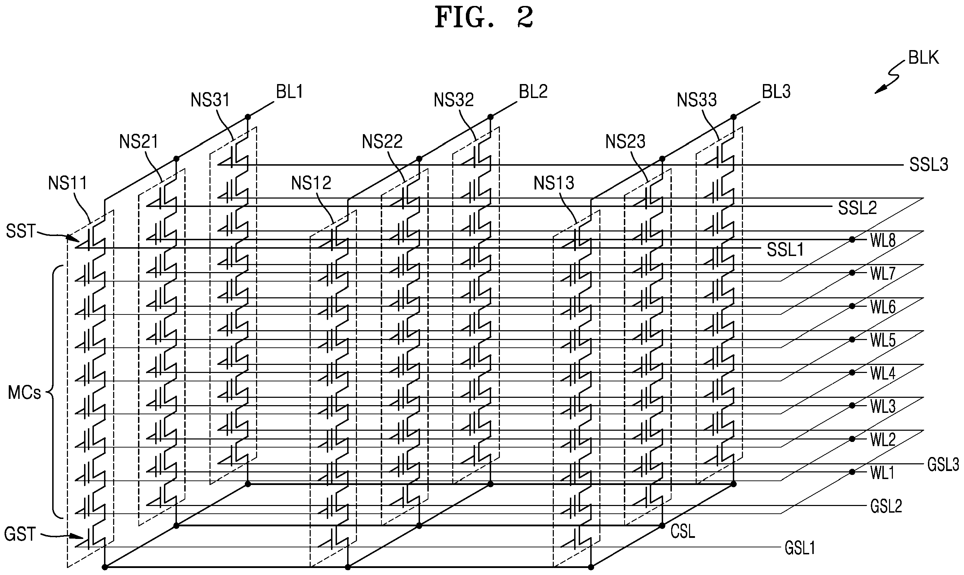

In an example embodiment, the memory cell array 11 may include a three-dimensional (3D) memory cell array, the 3D memory cell array may include a plurality of NAND strings, and each NAND string may include memory cells respectively connected to word lines vertically stacked on a substrate, as described in detail with reference to FIG. 2. U.S. Patent No. 7,679,133, U.S. Patent No. 8,553,466, U.S. Patent No. 8,654,587, U.S. Patent No. 8,559,235, and U.S. Application Publication No. 2011/0233648, the disclosures of which are incorporated herein in their entirety by reference, disclose details of suitable components of a 3D memory array at levels, in which word lines and/or bit lines are shared between the levels, which are incorporated herein by reference. However, the disclosure is not limited thereto, and as such, according to another embodiment, the memory cell array 11 may include a two-dimensional (2D) memory cell array, and the 2D memory cell array may include a plurality of NAND strings arranged in row and column directions.

The page buffer unit 12 may include a plurality of page buffers PB. The page buffers PB may be respectively connected to the memory cells of the memory cell array 11 through their corresponding bit lines. The page buffer unit 12 may select at least one of the bit lines BL under the control of the control logic circuit 13. For example, the page buffer unit 12 may select one or more of the bit lines BL based on a column address Y_ADDR signal received from the control logic circuit 13 and control voltages VY output from the voltage generator 14. For example, the page buffer unit 12 may select some of the bit lines BL in response receiving the column address Y_ADDR signal and the control voltages VY. Each of the page buffers PB may operate as a write driver or a sense amplifier. For example, in a program operation, each of the page buffers PB may apply, to the bit line, a voltage corresponding to data Y_DATA, which has been obtained by internally processing data DATA to be programmed through the control logic circuit 13, and store the data DATA in the memory cell. For example, in a program verify operation or a read operation, each of the page buffers PB may detect the data DATA programmed by internally processing data Y_DATA, which has been obtained by detecting a current or a voltage through a bit line.

Based on a command CMD, an address ADDR, the data DAT, and a control signal CTRL, the control logic circuit 13 may output various control signals, for example, a voltage control signal CTRL_vol, a row address X_ADDR, and a column address Y_ADDR, for programming data to the memory cell array 11, for reading data from the memory cell array 11, or for erasing data stored in the memory cell array 11. As a result, the control logic circuit 13 may generally control various operations within the memory device 10. For example, the control logic circuit 13 may receive the command CMD, the address ADDR, the data DATA, and the control signal CTRL from a memory controller.

The voltage generator 14 may generate various types of voltages for performing program, read, and erase operations on the memory cell array 11 based on a voltage control signal CTRL_vol. In detail, the voltage generator 14 may generate a word line voltage VWL, for example, a program voltage, a read voltage, a pass voltage, an erase verify voltage, or a program verify voltage, and may generate page buffer circuit control voltages VY, for example, a transistor gate voltage for supplying a BL voltage, or the like. In addition, the voltage generator 14 may further generate a string select line (SSL) voltage, a ground select line (GSL) voltage, and a common source line (CSL) voltage based on the voltage control signal CTRL_vol.

In response to the row address X_ADDR received from the control logic circuit 13, the row decoder 15 may select one of the memory blocks BLK1 to BLKz, may select one of word lines WL of the selected memory block, and may select one of the string select lines SSL. For example, during a program operation, the row decoder 15 may apply a program voltage and a program verify voltage to the selected word line WL and during a read operation, the row decoder 15 may apply a read voltage to the selected word line WL.

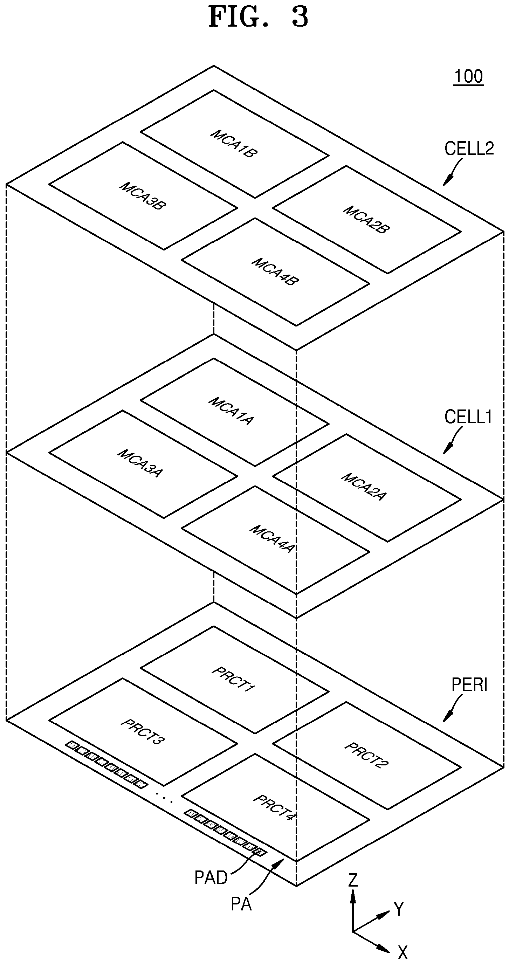

According to an example embodiment, the memory cell array 11 may be located in a first cell region CELL1 and a second cell region CELL2, and the peripheral circuit PRCT may be located in a peripheral circuit region PERI as illustrated in FIG. 3. At this time, at least a portion of the peripheral circuit PRCT may overlap the memory cell array 11 in the vertical direction.

FIG. 2 is a circuit diagram illustrating a memory block BLK according to an example embodiment.

Referring to FIG. 2, the memory block BLK may correspond to one of the memory blocks BLK1 to BLKz of FIG. 1. The memory block BLK may include NAND strings NS11 to NS33, and each NAND string (e.g., NS11) may include a string select transistor SST, a plurality of memory cells MCs, and a ground select transistor GST connected in series. The string select transistor SST and the ground select transistor GST and the memory cells MCs included in each NAND string may form a stacked structure on the substrate in the vertical direction.

Bit lines BL1 to BL3 may extend in a first direction (e.g., the Y direction of FIG. 3), and word lines WL1 to WL8 may extend in a second direction (e.g., the X direction of FIG. 3). According to an example embodiment, the first direction may be referred to as a first horizontal direction and the second direction may be referred to as a second horizontal direction. NAND strings NS11, NS21, and NS31 may be located between the first bit line BL1 and the common source line CSL, NAND strings NS12, NS22, and NS32 may be located between the second bit line BL2 and the common source line CSL, and NAND strings NS13, NS23, and NS33 may be located between the third bit line BL3 and the common source line CSL.

The string select transistor SST may be connected to corresponding string select lines SSL1 to SSL3. The memory cells MCs may be connected to corresponding word lines WL1 to WL8, respectively. The ground select transistor GST may be connected to corresponding ground select lines GSL1 to GSL3. The string select transistor SST may be connected to a corresponding bit line, and the ground select transistor GST may be connected to the common source line CSL. Here, the number of NAND strings, the number of word lines, the number of bit lines, the number of ground select lines, and the number of string select lines may be variously changed according to an example embodiment.

FIG. 3 schematically illustrates a structure of a memory device 100 according to an example embodiment.

Referring to FIG. 3, the memory device 100 may include a peripheral circuit region PERI, a first cell region CELL1, and a second cell region CELL2. The peripheral circuit region PERI, the first cell region CELL1, and the second cell region CELL2 are arranged in the vertical direction Z. For example, the peripheral circuit region PERI may be provided on a first layer, the first cell region CELL1 may be provided on a second layer above the first layer in the vertical direction Z, and the second cell region CELL2 may be provided on a third layer above the second layer in the vertical direction Z. The peripheral circuit region PERI may include a first peripheral circuit mat PRCT1, a second peripheral circuit mat PRCT2, a third peripheral circuit mat PRCT3, and a fourth peripheral circuit mat PRCT4. The first to fourth peripheral circuit mats PRCT1, PRCT2, PRCT3, and PRCT4 may be arranged in a matrix form. Here, the term "mat" may refer to a circuit being provided in a mat structure. Each of the first to fourth peripheral circuit mats PRCT1 to PRCT4 may include the peripheral circuit PRCT described above with reference to FIG. 1. The peripheral circuit region PERI may include a pad region PAin a portion of the peripheral circuit region PERI, and a pad PAD may be located in the pad region PA. In an example embodiment, the pad region PA may be provided at an edge of the peripheral circuit region PERI. For example, the pad region PA may be closer to the edge of the peripheral circuit region PERI than a center of the peripheral circuit region PERI. The pad PAD may be an input/output (I/O) terminal configured to receive power or a signal from an external device and supply the received power or signal to the first to fourth peripheral circuit mats PRCT1 to PRCT4 in the peripheral circuit region PERI.

The first cell region CELL1 may include a first low-level memory mat MCA1A, a second low-level memory mat MCA2A, a third low-level memory mat MCA3A, and a fourth low-level memory mat MCA4A. The first to fourth low-level memory mats MCA1A, MCA2A, MCA3A, and MCA4A may be arranged in a matrix form. The first to fourth low-level memory mats MCA1A to MCA4A may be arranged in positions vertically overlapping the first to fourth peripheral circuit mats PRCT1 to PRCT4, respectively. For example, the first low-level memory mat MCA1A may vertically overlap the first peripheral circuit mat PRCT1, the second low-level memory mat MCA2A may vertically overlap the second peripheral circuit mat PRCT2, the third low-level memory mat MCA3A may vertically overlap the third peripheral circuit mat PRCT3, and the fourth low-level memory mat MCA4A may vertically overlap the fourth peripheral circuit mat PRCT4. According to an embodiment, a low-level memory mat and a corresponding peripheral circuit mat may entirely overlap each other. However, the disclosure is not limited thereto, and as such, according to another embodiment, a low-level memory mat and a corresponding peripheral circuit mat may partially overlap each other. Each of the first to fourth low-level memory mats MCA1A to MCA4A may include the memory cell array 11 described above with reference to FIG. 1.

The second cell region CELL2 may include a first high-level memory mat MCA1B, a second high-level memory mat MCA2B, a third high-level memory mat MCA3B, and a fourth high-level memory mat MCA4B. The first to fourth high-level memory mats MCA1B, MCA2B, MCA3B, and MCA4B may be arranged in a matrix form. The first to fourth high-level memory mats MCA1B to MCA4B may be arranged in positions vertically overlapping the first to fourth low-level memory mats MCA1A to MCA4A, respectively, and also arranged in positions vertically overlapping the first to fourth peripheral circuit mats PRCT1 to PRCT4. For example, the first low-level memory mat MCA1A may vertically overlap the first high-level memory mat MCA1B, the second low-level memory mat MCA2A may vertically overlap the second high-level memory mat MCA2B, the third low-level memory mat MCA3A may vertically overlap the third high-level memory mat MCA3B, and the fourth low-level memory mat MCA4A may vertically overlap the fourth high-level memory mat MCA4B. According to an embodiment, a low-level memory mat and a corresponding high-level memory mat may entirely overlap each other. However, the disclosure is not limited thereto, and as such, according to another embodiment, a low-level memory mat and a corresponding high-level memory mat may partially overlap each other. Each of the first to fourth high-level memory mats MCA1B to MCA4B may include the memory cell array 11 described above with reference to FIG. 1.

Here, the terms "low-level" and "high-level" are used to indicate relative positions of a first component and a second component with respect to the peripheral circuit region PERI. For example, the first low-level memory mat MCA1A included in the first cell region CELL1 may be relatively close to the peripheral circuit region PERI, and the first high-level memory mat MCA1B included in the second cell region CELL2 may be located to be relatively far from the peripheral circuit region PERI. Accordingly, in an example embodiment, in an example in which the memory device 100 is installed and used in an external device, and the memory device 100 is oriented in a direction opposite to the orientation illustrated in FIG. 3, a "low-level" component may be at a higher vertical level than the "high-level" component, or conversely, the "low-level" component may be at a lower vertical level than the "high-level" component.

Although FIG. 3 illustrates that a pad PAD is located in the pad region PA of the peripheral circuit region PERI, the disclosure is not limited thereto, and as such, the pad PAD may also be located in the second cell region CELL2 according other example embodiments.

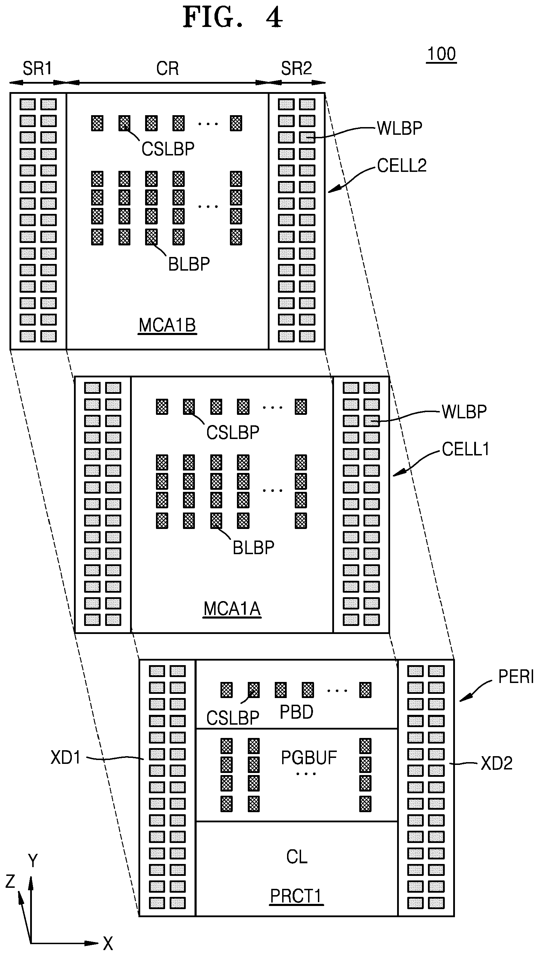

FIG. 4 is a diagram illustrating the memory device 100 according to an example embodiment.

Referring to FIG. 4, the first low-level memory mat MCA1A may include a cell region CR and one or more connection regions. For example, the one or more connection regions may include a first connection region SR1 provided on a first side of the cell region CR and a second connection region SR2 provided on a second side of the cell region CR. The second side may be opposite to the first side. The first high-level memory mat MCA1B may include a cell region CR and connection regions SR1 and SR2 located on both sides of the cell region CR. The cell region CR of the first high-level memory mat MCA1B may be located in a position corresponding to the cell region CR of the first low-level memory mat MCA1A or in a position vertically overlapping the cell region CR of the first low-level memory mat MCA1A.

According to an embodiment, the connection regions SR1 and SR2 may be provided on one side (i.e., on a same side) or in the center of the cell region CR.

The first peripheral circuit mat PRCT1 may include a page buffer circuit region PGBUF, a page buffer driver PBD, a control logic circuit region CL, and row decoder regions XD1 and XD2. For example, the page buffer circuit region PGBUF may be a region in which the page buffer unit 12 described above with reference to FIG. 1 is located. The control logic circuit region CL may be a region in which the control logic circuit 13 described above with reference to FIG. 1 is located. The row decoder regions XD1 and XD2 may be regions in which the row decoder 15 described above with reference to FIG. 1 is located. The row decoder regions XD1 and XD2 may be located in positions corresponding to the connection regions SR1 and SR2 of the first low-level memory mat MCA1A and the connection regions SR1 and SR2 of the first high-level memory mat MCA1B. For example, the row decoder regions XD1 and XD2 may vertically overlap the connection regions SR1 and SR2 of the first low-level memory mat MCA1A and the connection regions SR1 and SR2 of the first high-level memory mat MCA1B in the Z direction.

The first low-level memory mat MCA1A may be electrically connected to the first peripheral circuit mat PRCT1 by a bit line pad BLBP, a word line pad WLBP, and a common source line pad CSLBP of the first low-level memory mat MCA1A. The first high-level memory mat MCA1B may be electrically connected to the first low-level memory mat MCA1A by the bit line pad BLBP, the word line pad WLBP, and the common source line pad CSLBP of the first high-level memory mat MCA1B. Accordingly, the bit line of the first low-level memory mat MCA1A and the bit line of the first high-level memory mat MCA1B may be electrically connected to the page buffer circuit region PGBUF of the first peripheral circuit mat PRCT1 through the bit line pad BLBP. Also, the word line of the first low-level memory mat MCA1A and the word line of the first high-level memory mat MCA1B may be electrically connected to the row decoder regions XD1 and XD2 of the first peripheral circuit mat PRCT1 through the word line pad WLBP. The common source line of the first low-level memory mat MCA1A and the common source line of the first high-level memory mat MCA1B may be electrically connected to the page buffer driver PBD of the first peripheral circuit mat PRCT1 through the common source line pad CSLBP.

According to an embodiment, in the first low-level memory mat MCA1A and the first high-level memory mat MCA1B, the bit line pad BLBP may be divided into a plurality of regions.

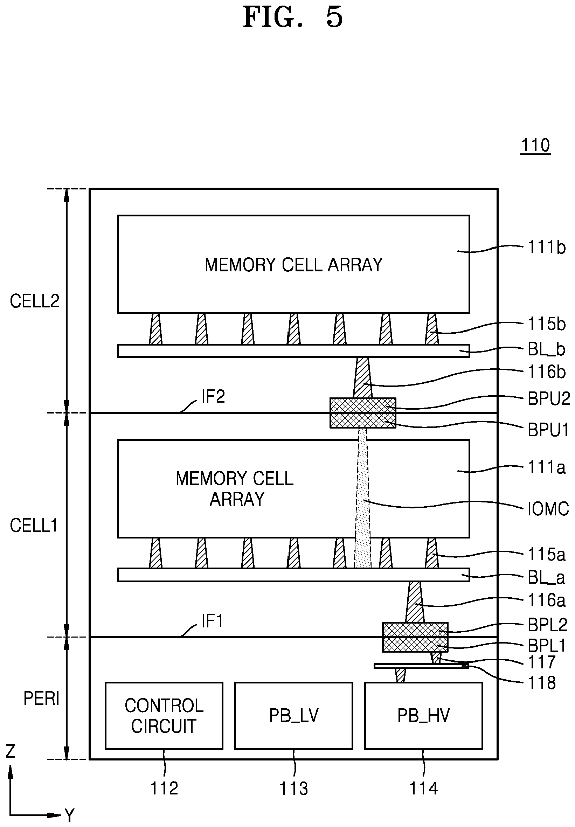

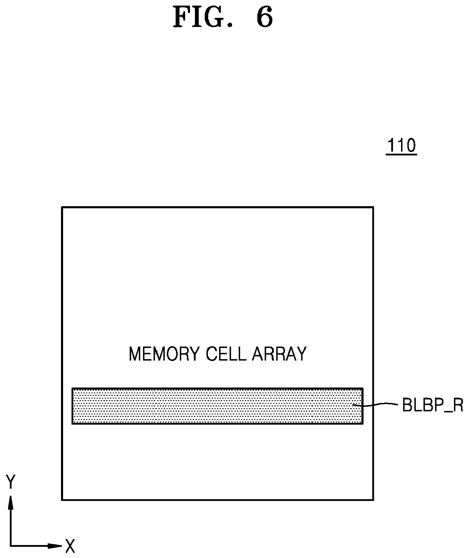

FIG. 5 is a diagram illustrating a memory device 110 according to an example embodiment. FIG. 6 is a plan view schematically illustrating the memory device 110 of FIG. 5.

Referring to FIGS. 5 and 6, a peripheral circuit region PERI, a first cell region CELL1, and a second cell region CELL2 may be arranged in the vertical direction Z. The peripheral circuit region PERI, the first cell region CELL1, and the second cell region CELL2 may be sequentially stacked in the vertical direction Z. A first memory cell array 111a may be located in the first cell region CELL1, and a second memory cell array 111b may be located in the second cell region CELL2. A control circuit 112, a low-voltage page buffer circuit (PB_LV) 113, and a high-voltage page buffer circuit (PB_HV) 114 may be located in the peripheral circuit region PERI.

The peripheral circuit region PERI may be attached to the first cell region CELL1 by low-level bonding pads BPL1 and BPL2 in a first bonding interface IF1, and the first cell region CELL1 may be connected to the second cell region CELL2 by high-level bonding pads BPU1 and BPU2 in a second bonding interface IF2. The low-level bonding pads BPL1 and BPL2 and the high-level bonding pads BPU1 and BPU2 may be located in a bit line bonding pad region BLBP_R located in the memory cell arrays 111a and 111b in a plan view shown in FIG. 6.

According to an embodiment, the bit line bonding pad region BLBP_R may be divided into a plurality of regions in the memory device 110. The plurality of bonding pad regions may be separated from each other.

The first memory cell array 111a in the first cell region CELL1 may be connected to a low-level bit line BL_a through a bit line contact 115a, and the low-level bit line BL_a may be electrically connected to the low-level bonding pads BPL1 and BPL2 through a connection via 116a. The second memory cell array 111b in the second cell region CELL2 may be connected to a high-level bit line BL_b through a bit line contact 115b, and the high-level bit line BL_b may be electrically connected to the high-level bonding pads BPU1 and BPU2 through a connection via 116b.

The first cell region CELL1 may further include an I/O contact IOMC, and the I/O contact IOMC may electrically connect the low-level bonding pads BPL1 and BPL2 to the high-level bonding pads BPU1 and BPU2 through a portion of the first memory cell array 111a. The low-level bonding pads BPL1 and BPL2 may be electrically connected to, for example, the high-voltage page buffer circuit 114 through a via 117 and a wiring layer 118 located in the peripheral circuit region PERI.

According to an example embodiment, the high-level bonding pads BPU1 and BPU2 provided at the second bonding interface IF2 may be arranged in a different manner than the low-level bonding pads BPL1 and BPL2 provided at the first bonding interface IF1. For example, planar positions of the high-level bonding pads BPU1 and BPU2 may be different from planar positions of the low-level bonding pads BPL1 and BPL2. For example, as shown in FIG. 5, the high-level bonding pads BPU1 and BPU2 may be provided to be laterally offset from the low-level bonding pads BPL1 and BPL2. Also, the I/O contact IOMC may directly connect the high-level bonding pads BPU1 and BPU2 to the low-level bit line BL_a between the high-level bonding pads BPU1 and BPU2 and the low-level bit line BL_a.

According to an example embodiment, the first memory cell array 111a in the first cell region CELL1 may store m bits per cell and the second memory cell array 111b in the second cell region CELL2 may store n bits per cell, where m and n are integers that are same as each other or different from each other. According to an embodiment, both the first and second memory cell arrays 111a and 111b may be single level cell memories that store 1 bit per cell. According to another embodiment, both the first and second memory cell arrays 111a and 111b may be multi-level cell memories that store 2 bits per cell. According to yet another embodiment, both the first and second memory cell arrays 111a and 111b may be triple level cell memories that store 3 bits per cell. According to an embodiment, the first memory cell array 111a may be a multi-level cell memory and the second memory cell array 111b may be a single-level cell memory. According to an embodiment, the first memory cell array 111a may be a triple-level cell memory and the second memory cell array 111b may be a multi-level cell memory or a single-level cell memory. According to another embodiment, the first memory cell array 111a may be a single-level cell memory and the second memory cell array 111b may be a multi-level cell memory. According to yet another embodiment, the first memory cell array 111a may be a multi-level cell memory or single-level cell memory and the second memory cell array 111b may be a triple-level cell memory.

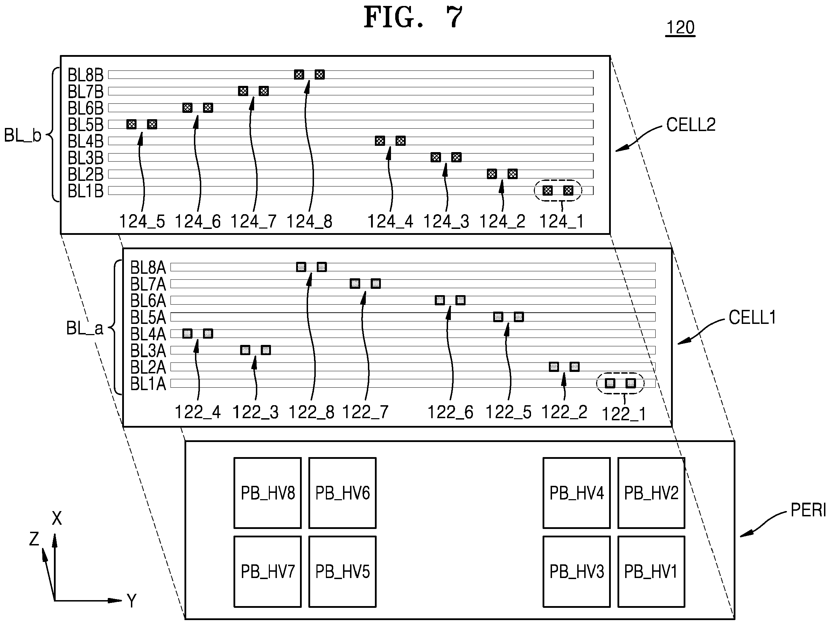

FIG. 7 is a diagram illustrating a memory device 120 according to an example embodiment.

FIG. 7 illustrates an arrangement of the low-level bit line BL_a, the high-level bit line BL_b, and the high-voltage page buffer circuit 114 described above with reference to FIG. 5. For example, first to eighth high-voltage page buffer circuits PB_HV1 to PB_HV8 are located in the peripheral circuit region PERI.

According to an embodiment, the first cell region CELL1 includes a low level bit line BL_a, which may include a set or a group of bit lines. For example, the set may include a first bit line BL1A, a second bit line BL2A, a third bit line BL3A, a fourth bit line BL4A, a fifth bit line BL5A, a sixth bit line BL6A, a seventh bit line BL7A, and an eighth bit line BL8A located in the first cell region CELL1. Although only one set of the low-level bit line BL_a is shown in FIG. 7 as an example, a plurality of sets of low-level bit lines BL_a may be repeatedly arranged at the same distance. Moreover, the disclosure is not limited to 8 bitlines per set, and as such, a number of bitlines per set may be different according to another embodiment. First to eighth low-level connection vias 122_1, 122_2, 122_3, 122_4, 122_5, 122_6, 122_7 and 122_8 may be connected to the first to eighth bit lines BL1A to BL8A, respectively. For example, the first to eighth low-level connection vias 122_1 to 122_8 may be a dual via type and each include a pair of vias apart from each other at a certain interval as shown in FIG. 7. However, the number of vias may be three or more (e.g., triple vias) instead of a pair. The first to eighth low-level connection vias 122_1 to 122_8 may be sequentially located in an extending direction (e.g., a second horizontal direction Y) of the low-level bit line BL_a.

For example, the first low-level connection via 122_1 may be connected to the first low-level bit line BL1A, the second low-level connection via 122_2 may be connected to the second low-level bit line BL2A, the third low-level connection via 122_3 may be connected to the third low-level bit line BL3A, the fourth low-level connection via 122_4 may be connected to the fourth low-level bit line BL4A, the fifth low-level connection via 122_5 may be connected to the fifth low-level bit line BL5A, the sixth low-level connection via 122_6 may be connected to the sixth low-level bit line BL6A, the seventh low-level connection via 122_7 may be connected to the seventh low-level bit line BL7A, and the eighth low-level connection via 122_8 may be connected to the eighth low-level bit line BL8A.

In addition, a combination of the first to eighth low-level connection vias 122_1 to 122_8 and the low-level bit line BL_a connected to the first to eighth low-level connection vias 122_1 to 122_8 may be only an example embodiment selected for optimized connection from the first to eighth high-voltage page buffer circuits PB_HV1 to PB_HV8 to the low-level bit line BL_a. As such, according to another embodiment, the order of the first to eighth bit lines BL1A to BL8A in the low-level bit line BL_a corresponding to the first to eighth low-level connection vias 122_1 to 122_8 may vary. Also, the positions of the first to eighth low-level connection vias 122_1 to 122_8 the first to eighth bit lines BL1A to BL8A may vary.

According to an embodiment, the second cell region CELL2 includes a high-level bit line BL_b, which may include a set or a group of bit lines. For example, the set may include a first bit line BL1B, a second bit line BL2B, a third bit line BL3B, a fourth bit line BL4B, a fifth bit line BL5B, a sixth bit line BL6B, a seventh bit line BL7B, and an eighth bit line BL8B is located in the second cell region CELL2. First to eighth high-level connection vias 124_1 to 124_8 may be connected to the high-level bit lines BL_b, respectively. For example, the first to eighth high-level connection vias 124_1 to 124_8 may be a dual via type and include a pair of vias apart from each other at a certain interval, as shown in FIG. 7. However, the number of vias may be three or more (e.g., triple vias) instead of a pair. The first to eighth high-level connection vias 124_1 to 124_8 may be sequentially located in an extending direction (e.g., the second horizontal direction Y) of the high-level bit line BL_b.

At least one of the first to eighth high-level connection vias 124_1 to 124_8 may be located in a position that does not vertically overlap the corresponding first to eighth low-level connection vias 122_1 to 122_8, for example, in a position offset in the second horizontal direction Y.

For example, the first high-level connection via 124_1 may be connected to the first high-level bit line BL1B, the second high-level connection via 124_2 may be connected to the second high-level bit line BL2B, the third high-level connection via 124_3 may be connected to the third high-level bit line BL3B, the fourth high-level connection via 124_4 may be connected to the fourth high-level bit line BL4B, the fifth high-level connection via 124_5 may be connected to the fifth high level bit line BL5B, the sixth high-level connection via 124_6 may be connected to the sixth high-level bit line BL6B, the seventh high-level connection via 124_7 may be connected to the seventh high-level bit line BL7B, the eighth high-level connection via 124_8 may be connected to the eighth high-level bit line BL8B.

The first and second high-level connection vias 124_1 and 124_2 may be located in positions vertically overlapping the first and second low-level connection vias 122_1 and 122_2, respectively, but the third to eighth high-level connection vias 124_3 to 124_8 may be located in positions that do not vertically overlap the third to eighth low-level connection vias 122_3 to 122_8, respectively.

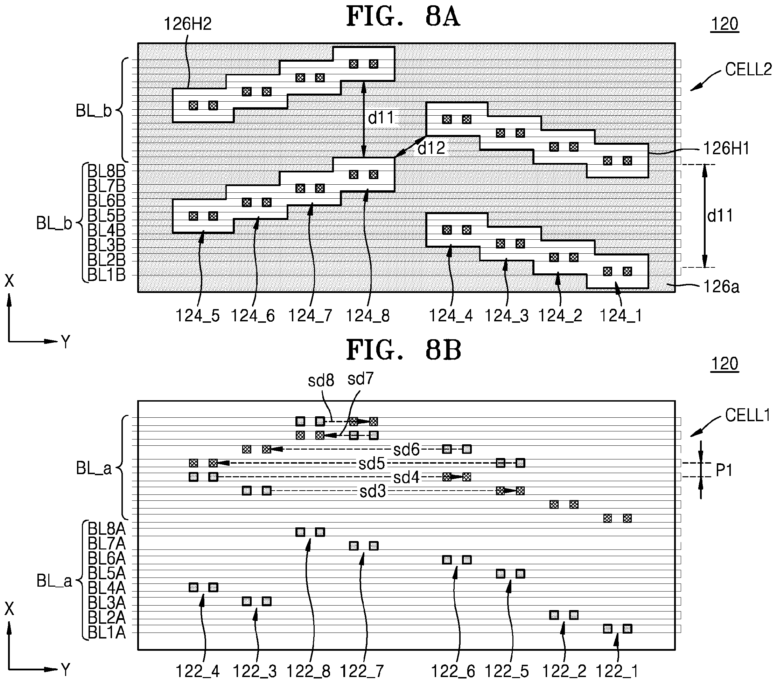

FIGS. 8A and 8B are plan layout diagrams of the memory device 120 according to an example embodiment.

FIG. 8A illustrates positions of the high-level bit line BL_b and the first to eighth high-level connection vias 124_1 to 124_8 included in the second cell region CELL2 and FIG. 8B illustrates positions of the low-level bit line BL_a and the first to eighth low-level connection vias 122_1 to 122_8 included in the first cell region CELL1 together with positions of the high-level bit line BL_b and the first to eighth high-level connection vias 124_1 to 124_8 included in the second cell region CELL2. In FIGS. 8A, two sets of high-level bit line BL_b is illustrated, and in FIG. 8B, two sets of low-level bit line BL_a are illustrated.

The first to eighth high-level connection vias 124_1 to 124_8 may be located in positions overlapping first and second openings 126H1 and 126H2 penetrating a common source plate 126a. For example, the first opening 126H1 may surround the first to fourth high-level connection vias 124_1 to 124_4 and the second opening 126H2 may surround the fifth to eighth high-level connection vias 124_5 to 124_8 in a plan view. The first to fourth high-level connection vias 124_1 to 124_4 may be arranged to be connected to the first to fourth high-level bit lines BL1B to BL4B, respectively, and may be apart from each other at a distance corresponding to a bit line pitch P1 in the horizontal direction X. In addition, the fifth to eighth high-level connection vias 124_5 to 124_8 may be arranged to be connected to the fifth to eighth high-level bit lines BL5B to BL8B, respectively, and may be apart from each other at a distance corresponding to the bit line pitch P1 in the horizontal direction X.

The two adjacent first openings 126H1 may be apart from each other by a first distance d11, and the first opening 126H1 may be apart from the second opening 126H2 adjacent thereto by a second distance d12. According to an example embodiment, the second distance d12 may correspond to about 60 % of the first distance d11 to about 200 % of the first distance d11.

According to an embodiment, in an example in which the bit line pad BLBP described above with reference to FIG. 4 is divided into a plurality of regions, the second distance d12 may be excessively large compared to the first distance d11. In an example in which the bit line bonding pad region BLBP_R described above with reference to FIG. 6 is divided into a plurality of regions, the second distance d12 may be excessively large compared to the first distance d11.

According to an example embodiment, the first opening 126H1 may be apart from the second opening 126H2 by the relatively large second distance d12, and the minimum width of the common source plate 126a located between the first opening 126H1 and the second opening 126H2 may also correspond to the relatively large second distance d12. Thus, the common source plate 126a may have reduced resistance.

For comparison, the positions of the first to eighth high-level connection vias 124_1 to 124_8 are shown by the dotted lines in a plan view of the first cell region CELL1 of FIG. 8B. The first high-level connection via 124_1 is located in a position vertically overlapping the first low-level connection via 122_1, and the second high-level connection via 124_2 is located in a position vertically overlapping the second low-level connection via 122_2. However, the third high-level connection via 124_3 may be located in a position that does not vertically overlap the third low-level connection via 122_3. For example, the third high-level connection via 124_3 may be offset or spaced apart from the third low-level connection via 122_3 by a third offset distance sd3 in the second horizontal direction Y. In addition, the fourth high-level connection via 124_4 may be located in a position that does not vertically overlap the fourth low-level connection via 122_4 and may be offset or spaced apart from the fourth low-level connection via 122_4 by a fourth offset distance sd4 in the second horizontal direction Y. Similarly, the fifth to eighth high-level connection vias 124_5 to 124_8 may be respectively offset or spaced apart from the fifth to eighth low-level connection vias 122_5 to 122_8 by fifth to eighth offset distances sd5 to sd8 in the second horizontal direction Y.

The first high-level connection via 124_1 may be in the same position as the first low-level connection via 122_1 in the second horizontal direction Y, and the second high-level connection via 124_2 may be in the same position as the second low-level connection via 122_2 in the second horizontal direction Y.

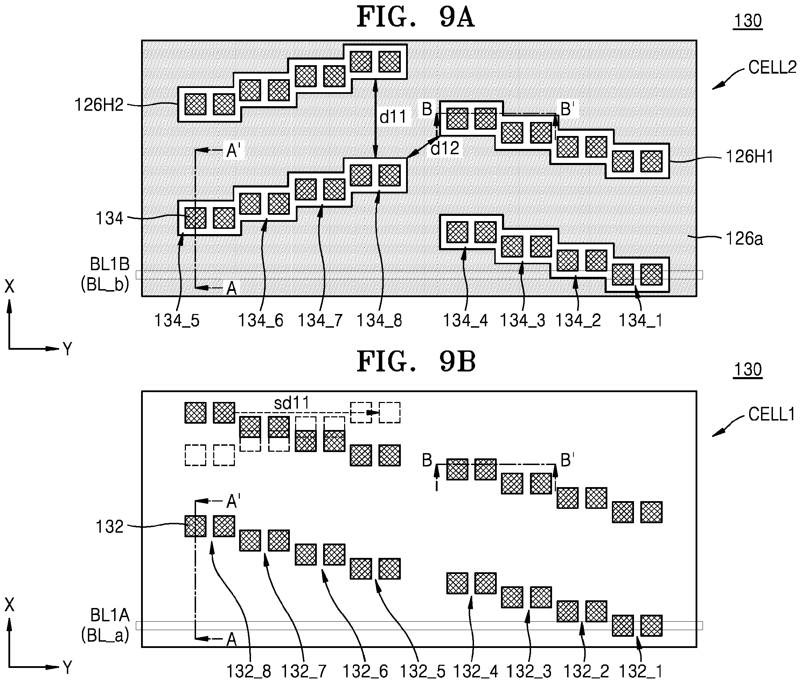

FIGS. 9A and 9B are plan layout diagrams of a memory device 130 according to an example embodiment.

Referring to FIG. 9B, a low-level bonding pad 132 may be located in the first bonding interface IF1 (see FIG. 5) between the peripheral circuit region PERI and the first cell region CELL1 and may include first to eighth low-level bonding pads 132_1 to 132_8. Each of the first to eighth low-level bonding pads 132_1 to 132_8 may have a dual pad shape, and for example, the first low-level bonding pad 132_1 may include a pair of bonding pads apart in the second horizontal direction Y. However, the number of low-level bonding pads may be three or more (e.g., triple bonding pads, etc.) instead of a pair.

The first to eighth low-level bonding pads 132_1 to 132_8 may be sequentially located in the extending direction (e.g., the second horizontal direction Y) of the low-level bit line BL_a. The first to eighth low-level bonding pads 132_1 to 132_8 may be arranged to be offset at a certain interval (e.g., at an interval corresponding to a bit line pitch P1) in the first horizontal direction X.

Referring to FIG. 9A, the high-level bonding pad 134 may be located in the second bonding interface IF2 (see FIG. 5) between the first cell region CELL1 and the second cell region CELL2 and may include first to eighth high-level bonding pads 134_1 to 134_8. Each of the first to eighth high-level bonding pads 134_1 to 134_8 may have a dual pad shape, and, for example, the first high-level bonding pad 134_1 may include a pair of bonding pads apart in the second horizontal direction Y. However, the number of high-level bonding pads may be three or more (for example, triple bonding pads, etc.) instead of a pair.

The first to eighth high-level bonding pads 134_1 to 134_8 may have a planar arrangement that is different from that of the first to eighth low-level bonding pads 132_1 to 132_8. For example, the first to fourth high-level bonding pads 134_1 to 134_4 may be provided to be offset at a certain interval (corresponding to the bit line pitch P1, for example) in the first horizontal direction X and may be located in a position corresponding to the first opening 126H1 of the first common source plate 126a. For example, in a plan view, the first to fourth high-level bonding pads 134_1 to 134_4 may overlap the first opening 126H1 of the first common source plate 126a. The fifth to eighth high-level bonding pads 134_5 to 134_8 may be arranged to be offset at a certain interval (e.g., at an interval corresponding to the bit line pitch P1) in the first horizontal direction X and may be located in a position corresponding to the second opening 126H2 of the first common source plate 126a. For example, in a plan view, the fifth to eighth high-level bonding pads 134_5 to 134_8 may overlap the second opening 126H2 of the first common source plate 126a.

The first to eighth low-level bonding pads 132_1 to 132_8 may be sequentially provided in the extending direction (e.g., the second horizontal direction Y) of the low-level bit line BL_a. The first to fourth high-level bonding pads 134_1 to 134_4 and the eighth to fifth high-level bonding pads 134_8 to 134_5 may be sequentially arranged in an extending direction (e.g., the second horizontal direction Y) of the high-level bit line BL_b.

For comparison, positions of the first to eighth high-level bonding pads 134_1 to 134_8 are shown with the dashed lines in a plan view of the first cell region CELL1 of FIG. 9B. The first to fourth high-level bonding pads 134_1 to 134_4 may be located in positions vertically overlapping the first to fourth low-level bonding pads 132_1 to 132_4, while the fifth to eighth high-level bonding pads 134_5 to 134_8 may be located in positions not vertically overlapping the fifth to eighth low-level bonding pads 132_5 to 132_8 corresponding thereto. For example, the eighth high-level bonding pad 134_8 may be offset or spaced apart from the eighth low-level bonding pad 132_8 by an offset distance sd11 in the second horizontal direction Y.

According to an example embodiment, as the first to eighth high-level bonding pads 134_1 to 134_8 have a planar arrangement shape that is different from that of the first to eighth low-level bonding pads 132_1 to 132_8, an optimized electrical connection may be obtained between the low-level bit line BL_a and the peripheral circuit region PERI. In addition, a relatively large distance may be secured between the first opening 126H1 and the second opening 126H2 of the first common source plate 126a to reduce resistance of the first common source plate 126a, and accordingly, noise of the common source line or noise of a read operation may be reduced. Also, the first to eighth low-level bonding pads 132_1 to 132_8 and the first to eighth high-level bonding pads 134_1 to 134_8 may be arranged at a uniform pitch, and accordingly, the first to eighth low-level bonding pads 132_1 to 132_8 and the first to eighth high-level bonding pads 134_1 to 134_8 may have a relatively wide pitch.

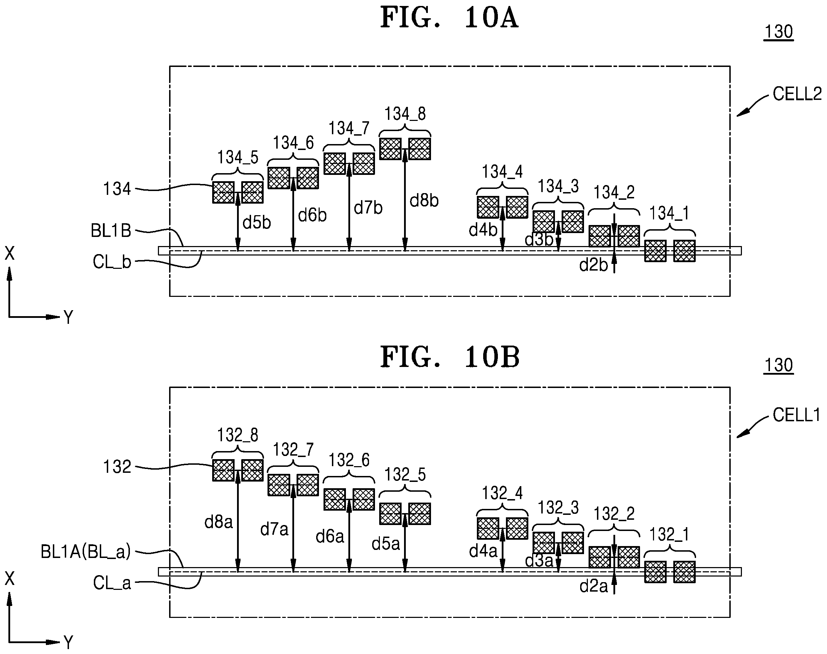

FIGS. 10A and 10B are schematic diagrams illustrating an example of an arrangement of bonding pads of the memory device 130 of FIGS. 9A and 9B.

Referring to FIG. 10B, the first to eighth low-level bonding pads 132_1 to 132_8 may be shifted or offset at certain intervals in the first horizontal direction X and the second horizontal direction Y. Referring to FIG. 10A, the first to eighth high-level bonding pads 134_1 to 134_8 may be shifted or offset at certain intervals in the first horizontal direction X and the second horizontal direction Y. In FIG. 10B, a center line CL_a of the first low-level bit line BL1A vertically overlapping the first low-level bonding pad 132_1 is indicated by the dashed line, and in FIG. 10A, a center line CL_b of the first high-level bit line BL1B vertically overlapping the first high-level bonding pad 134_1 is indicated by the dashed line.

The second low-level bonding pads 132_2 to the eighth low-level bonding pads 132_8 may be apart from the center line CL_a of the first low-level bit line BL1A by second to eighth distances d2a to d8a, respectively, in the first horizontal direction X. The second to eighth distances d2a to d8a may be distances from a portion of the first low-level bonding pad 132_1 vertically overlapping the center line CL_a of the first low-level bit line BL1A to the second low-level bonding pad 132_2 to the eighth low-level bonding pad 132, respectively, in the first horizontal direction X.

According to an embodiment, the second to eighth distances d2a to d8a may have gradually or sequentially increasing values.

For example, the second to eighth distances d2a to d8a may satisfy the following criteria: d2a < d3a < d4a < d5a < d6a < d7a < d8a.

For example, the third distance d3a may be greater than the second distance d2a, and the fourth distance d4a may be greater than the third distance d3a. According to an embodiment, the difference between the third distance d3a and the second distance d2a may be equal to or different from the difference between the fourth distance d4a and the third distance d3a.

The second high-level bonding pad 134_2 to the eighth high-level bonding pad 134_8 may be apart from the center line CL_b of the first high-level bit line BL1B by second to eighth distances d2b to d8b, respectively, in the first horizontal direction X. The second to eighth distances d2b to d8b may be distances from a portion of the first high-level bonding pad 134_1 vertically overlapping the center line CL_b of the first high-level bit line BL1B to the second high-level bonding pad 134_2 to the eighth high-level bonding pad 134_8, respectively, in the first horizontal direction X.

According to an embodiment, the second to fourth distances d2b to d4b may have gradually or sequentially increasing values, and the fifth to eighth distances d5b to d8b may have gradually or sequentially increasing values.

For example, the second to fourth distances d2b to d4b may satisfy the following criteria: d2b < d3b < d4b.

For example, the fifth to eighth distances d5b to d8b may satisfy the following criteria: d5b < d6b < d7b < d8b.

For example, the third distance d3b may be greater than the second distance d2b, and the fourth distance d4b may be greater than the third distance d3b. Also, the sixth distance d6b may be greater than the fifth distance d5b, the seventh distance d7b may be greater than the sixth distance d6b, and the eighth distance d8b may be greater than the seventh distance d7b. In addition, the fifth distance d5b may be greater than the fourth distance d4b.

The low-level connection vias 122_1 to 122_8 and the low-level bonding pads 132_1 to 132_8 described above with reference to FIGS. 7 to 10 may be periodically arranged based on eight low-level bit lines BL_a as a repeating unit, and the high-level connection vias 124_1 to 124_8 and the high-level bonding pads 134_1 to 134_8 may be periodically arranged based on eight high-level bit lines BL_b as a repeating unit. According to an embodiment, depending on a bit line pitch or a bonding pad pitch, one repeating unit may be 4, 6, 8, 12, 16, 24, and 32, and the low-level connection vias 122_1 to 122_8, the low-level bonding pads 132_1 to 132_8, the high-level connection vias 124_1 to 124_8, and the high-level bonding pads 134_1 to 134_8 may be periodically arranged based on a different number of bit lines as a repeating unit.

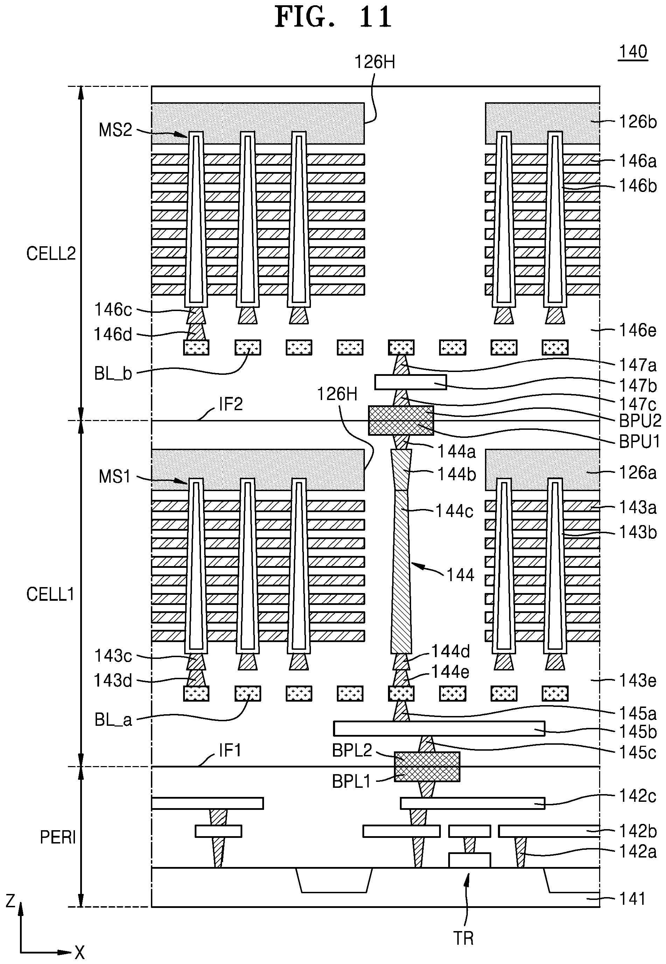

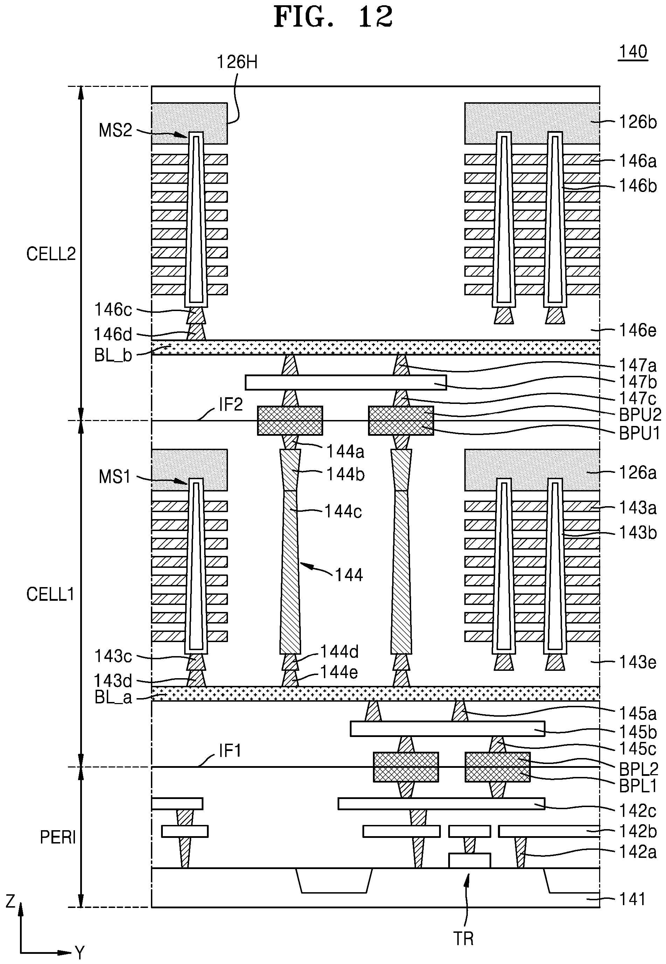

FIGS. 11 and 12 are cross-sectional views illustrating a memory device 140 according to an example embodiment. FIG. 11 a schematic cross-sectional view taken along line A-A' of FIGS. 9A and 9B, and FIG. 12 is a schematic cross-sectional view taken along line B-B' of FIGS. 9A and 9B.

Referring to FIGS. 11 and 12, the peripheral circuit region PERI may include a first substrate 141, a transistor TR formed on the first substrate 141, vias 142a, a wiring layer 142b, and an insulating layer 142c. According to an embodiment, the transistor TR may include any one of the control circuit 112, the low-voltage page buffer circuit (PB_LV) 113, and the high-voltage page buffer circuit (PB_HV) 114 described above with reference to FIG. 5. Although the wiring layers 142b are illustrated as having a two-layer structure provided on different levels, the number of wiring layers 142b may range from three to eight layers.

The peripheral circuit region PERI may further include a lower low-level bonding pad BPL1. The lower low-level bonding pad BPL1 may be provided at the first bonding interface IF1 together with the insulating layer 142c.

The first cell region CELL1 may include an upper low-level bonding pad BPL2 provided at the first bonding interface IF1, and the upper low-level bonding pad BPL2 may be bonded to the lower low-level bonding pad BPL1 so that the first cell region CELL1 may be electrically or physically connected to the peripheral circuit region PERI. According to an example embodiment, the upper low-level bonding pad BPL2 may be attached to the lower low-level bonding pad BPL1 using a Cu-to-Cu bonding method. Here, the terms "upper" and "lower" are used to distinguish between two components having different distances from the peripheral circuit region PERI. The "upper" low-level bonding pad BPL2 is provided relatively far from the peripheral circuit region PERI, and the "lower" low-level bonding pad BPL1 is provided relatively close to the peripheral circuit region PERI.

The first cell region CELL1 may include a first common source plate 126a, a first memory string MS1 connected to the first common source plate 126a and extending in the vertical direction Z, and the low-level bit line BL_a electrically connected to the first memory string MS1. For example, the first memory string MS1 may include a plurality of word lines 143a apart from each other in the vertical direction Z and a channel structure 143b extending in the vertical direction Z through the word lines 143a. A stud 143c and a bit line contact 143d may be sequentially located between the channel structure 143b and the low-level bit line BL_a. The low-level bit line BL_a may be located relatively close to the peripheral circuit region PERI, and the first common source plate 126a may be provided relatively far from the peripheral circuit region PERI.

The first common source plate 126a may include an opening 126H, and the opening 126H may have a planar shape shown in FIG. 9A. The opening 126H may indicate a region in which a portion of the first common source plate 126a is removed. As shown in FIG. 11, some of the word lines 143a located in a position vertically overlapping the opening 126H may also be removed, and the insulating layer 143e may be located in a region from which the opening 126H and some of the word lines 143a are removed.

The first cell region CELL1 may include a lower high-level bonding pad BPU1 located on the second bonding interface IF2 and may include a connection via structure 144 located between the low-level bit line BL_a and the lower high-level bonding pad BPU1. The connection via structure 144 has a relatively small width in the first horizontal direction X and the second horizontal direction Y and may extend in the vertical direction Z to have a relatively large height in the vertical direction Z.

According to an example embodiment, the connection via structure 144 may include a first connection via 144a, a second connection via 144b, a third connection via 144c, a fourth connection via 144d, and a fifth connection via 144e. The first connection via 144a may contact the lower high-level bonding pad BPU1, and the second connection via 144b may be located at a vertical level similar to that of the first common source plate 126a. The third connection via 144c may extend in the vertical direction Z to have a height similar to that of the channel structure 143b in the vertical direction Z. The fourth connection via 144d may have a shape or height similar to that of the stud 143c, and the fifth connection via 144e may have a shape or height that is the same as or similar to that of the bit line contact 143d.

Although the connection via structure 144 is illustrated to have a connection structure of five vias (the first to fifth connection vias 144a to 144e), the disclosure is not limited to thereto. As such, according to another embodiment, the number of vias of the connection structure 144 may be different than five. For example, the connection via structure 144 may have a connection structure of three or more vias. For example, the first connection via 144a may be integrally merged with the second connection via 144b, or the fourth connection via 144d may be integrally merged with the fifth connection via 144e.

The connection via structure 144 may be located in a planar position corresponding to the opening 126H of the first common source plate 126a. For example, a portion of the connection via structure 144 may be surrounded planarly by the opening 126H of the first common source plate 126a, and the insulating layer 143e may be located between the connection via structure 144 and the word lines 143a.

A first via 145a, a wiring layer 145b, and a second via 145c may be sequentially located between the low-level bit line BL_a and the upper low-level bonding pad BPL2. For example, the first via 145a may be located to be connected to the low-level bit line BL_a in a position vertically overlapping the low-level bit line BL_a, the second via 145c may be located to be connected to the upper low-level bonding pad BPL2 in a position vertically overlapping the upper low-level bonding pad BPL2, and the wiring layer 145b may extend with a certain width in the first horizontal direction X to be connected to both the first via 145a and the second via 145c.

According to an example embodiment, the first via 145a may correspond to the first to eighth low-level connection vias 122_1 to 122_8 described above with reference to FIGS. 7 and 8. The upper low-level bonding pad BPL2 and the lower low-level bonding pad BPL1 may correspond to the first to eighth low-level bonding pads 132_1 to 132_8 described above with reference to FIG. 9B.

The second cell region CELL2 may include an upper high-level bonding pad BPU2 provided at the second bonding interface IF2, and the upper high-level bonding pad BPU2 may be bonded to the lower high-level bonding pad BPU1, so that the second cell region CELL2 may be electrically or physically connected to the first cell region CELL1. According to an example embodiment, the upper high-level bonding pad BPU2 may be attached to the lower high-level bonding pad BPU1 using Cu-to-Cu bonding.

The second cell region CELL2 may include a second common source plate 126b, a second memory string MS2 connected to the second common source plate 126b and extending in the vertical direction Z, and a high-level bit line BL_b electrically connected to the second memory string MS2. For example, the second memory string MS2 may include a plurality of word lines 146a apart from each other in the vertical direction Z and a channel structure 146b extending in the vertical direction Z through the word lines 146a. A stud 146c and a bit line contact 146d may be sequentially located between the channel structure 146b and the high-level bit line BL_b. The high-level bit line BL_b may be located relatively close to the peripheral circuit region PERI, and the second common source plate 126b may be provided relatively far from the peripheral circuit region PERI.

A first via 147a, a wiring layer 147b, and a second via 147c may be sequentially located between the high-level bit line BL_b and the upper high-level bonding pad BPU2. For example, the first via 147a may be located to be connected to the high-level bit line BL_b in a position vertically overlapping the high-level bit line BL_b, the second via 147c may be located to be connected to the upper high-level bonding pad BPU2 in a position vertically overlapping the upper high-level bonding pad BPU2, and the wiring layer 147b may extend with a certain width in the first horizontal direction X to be connected to both the first via 147a and the second via 147c.

According to an example embodiment, the first via 147a may correspond to the first to eighth high-level connection vias 124_1 to 124_8 described above with reference to FIGS. 7 and 8. The upper high-level bonding pad BPU2 and the lower high-level bonding pad BPU1 may correspond to the first to eighth high-level bonding pads 134_1 to 134_8 described above with reference to FIG. 9A.

According to an example embodiment, that the high-level first via 147a is offset or spaced apart from the low-level first via 145a in the second horizontal direction Y in FIG. 12 may correspond to that the third to eighth high-level connection vias 124_3 to 124_8 described above with reference to FIGS. 8A and 8B are offset or spaced apart from each other by the offset distances sd3 to sd8 from the low-level connection vias 122_3 to 122_8 in the second horizontal direction Y. That the upper high-level bonding pad BPU2 and the lower high-level bonding pad BPU1 are offset or spaced apart from the upper low-level bonding pad BPL2 and the lower low-level bonding pad BPL1 in the second horizontal direction Y in FIG. 12 may correspond to that the fifth to eighth high-level bonding pads 134_5 to 134_8 described above with reference to FIGS. 9A and 9B are offset or spaced apart by the offset distance sd1 1 from the fifth to eighth low-level bonding pads 132_5 to 132_8 in the second horizontal direction Y.

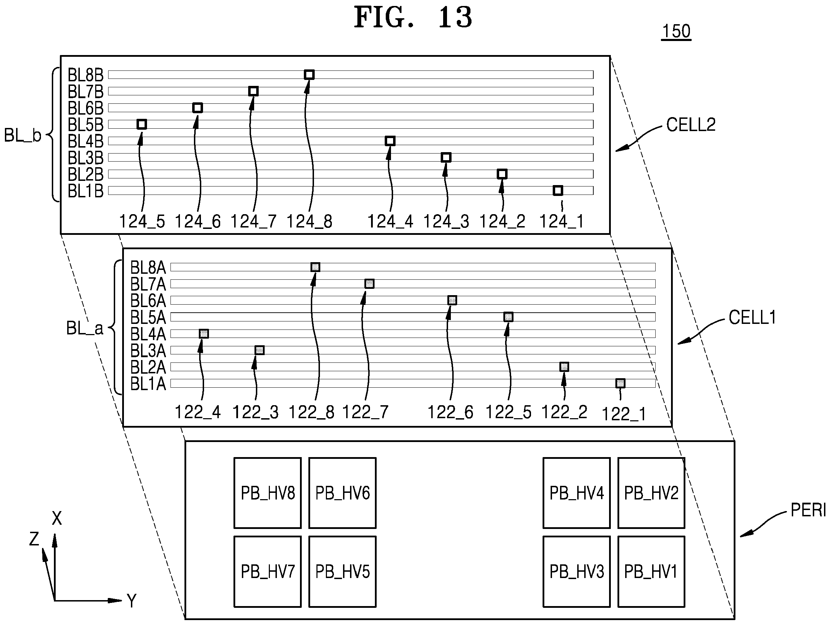

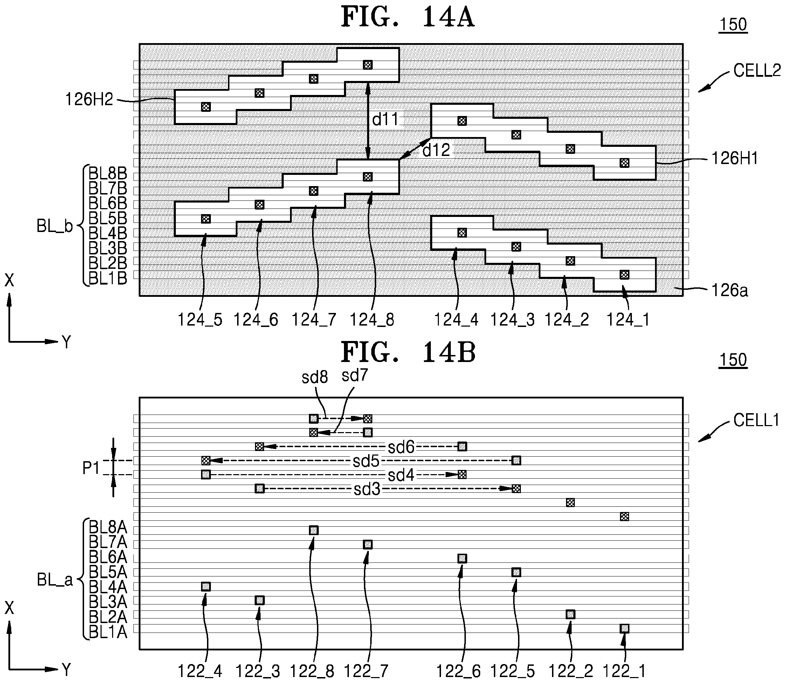

FIG. 13 is a schematic diagram illustrating a memory device 150 according to an example embodiment. FIGS. 14A and 14B are plan layout diagrams illustrating the memory device 150 of FIG. 13.

Referring to FIGS. 13, 14A and 14B, the first cell region CELL1 may include first to eighth low-level connection vias 122_1 to 122_8, and the first to eighth low-level connection vias 122_1 to 122_8 may have a single via shape. The second cell region CELL2 may include first to eighth high-level connection vias 124_1 to 124_8, and the first to eighth high-level connection vias 124_1 to 124_8 may have a single via shape.

According to an example embodiment, the first to fourth high-level connection vias 124_1 to 124_4 may be located to be offset or spaced apart by certain intervals in the first horizontal direction X and the second horizontal direction Y in a plan view and may be surrounded by the first opening 126H1 of the first common source plate 126a. The fifth to eighth high-level connection vias 124_5 to 124_8 may be offset or spaced apart from each other at certain intervals in the first horizontal direction X and the second horizontal direction Y, and may be surrounded by the second opening 126H2 of the first common source plate 126a. The first opening 126H1 and the second opening 126H2 may have a planar shape including a plurality of step portions offset from each other in the first horizontal direction X and the second horizontal direction Y.

According to an another example embodiment, the first to eighth low-level connection vias 122_1 to 122_8 may be formed in a dual via type as described above with reference to FIG. 7, and the first to eighth high-level connection vias 124_1 to 124_8 may be formed in a single via type as described above with reference to FIGS. 13, 14A and 14B. According to an another example embodiment, the first to eighth low-level connection vias 122_1 to 122_8 may be formed in a single via type as described above with reference to FIGS. 13, 14A and 14B, and the first to eighth high-level connection vias 124_1 to 124_8 may be formed in a dual via type as described above with reference to FIG. 7.

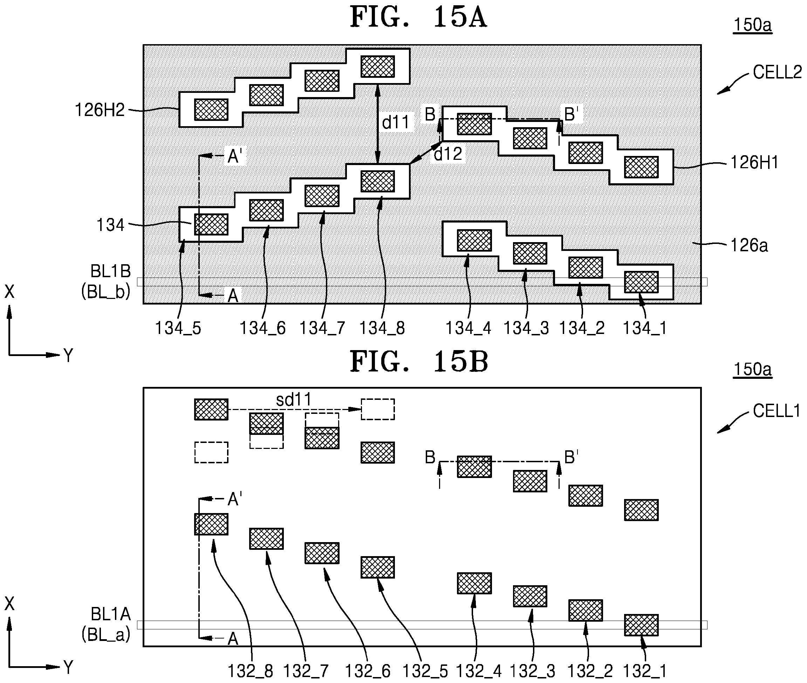

FIGS. 15A and 15B are schematic diagrams illustrating a memory device 150a according to an example embodiment.

Referring to FIG. 15B, the first cell region CELL1 may include first to eighth low-level bonding pads 132_1 to 132_8, and the first to eighth low-level bonding pads 132_1 to 132_8 have a single pad shape. Referring to FIG. 15A, the second cell region CELL2 may include first to eighth high-level bonding pads 134_1 to 134_8, and the first to eighth high-level bonding pads 134_1 to 134_8 may have a single pad shape.

According to an example embodiment, in a plan view, the first to fourth high-level bonding pads 134_1 to 134_4 may be located to be offset or spaced apart at certain intervals in the first horizontal direction X and the second horizontal direction Y, and may overlap the first opening 126H1 of the first common source plate 126a. The fifth to eighth high-level bonding pads 134_5 to 134_8 may be offset or spaced apart from each other at certain intervals in the first horizontal direction X and the second horizontal direction Y, and may overlap the second opening 126H2 of the first common source plate 126a. The first opening 126H1 and the second opening 126H2 may have a planar shape including a plurality of step portions offset from each other in the first horizontal direction X and the second horizontal direction Y.

According to an another example embodiment, the first to eighth low-level bonding pads 132_1 to 132_8 may be formed in a dual pad type as described above with reference to FIG. 9B, and the first to eighth high-level bonding pads 134_1 to 134_8 may be formed in a single pad type as described above with reference to FIG. 15A. According to an another example embodiment, the first to eighth low-level bonding pads 132_1 to 132_8 may be formed in a single pad type as described above with reference to FIG. 15B, and the first to eighth high-level bonding pads 134_1 to 134_8 may be formed in a dual pad type as described above with reference to FIG. 9A.

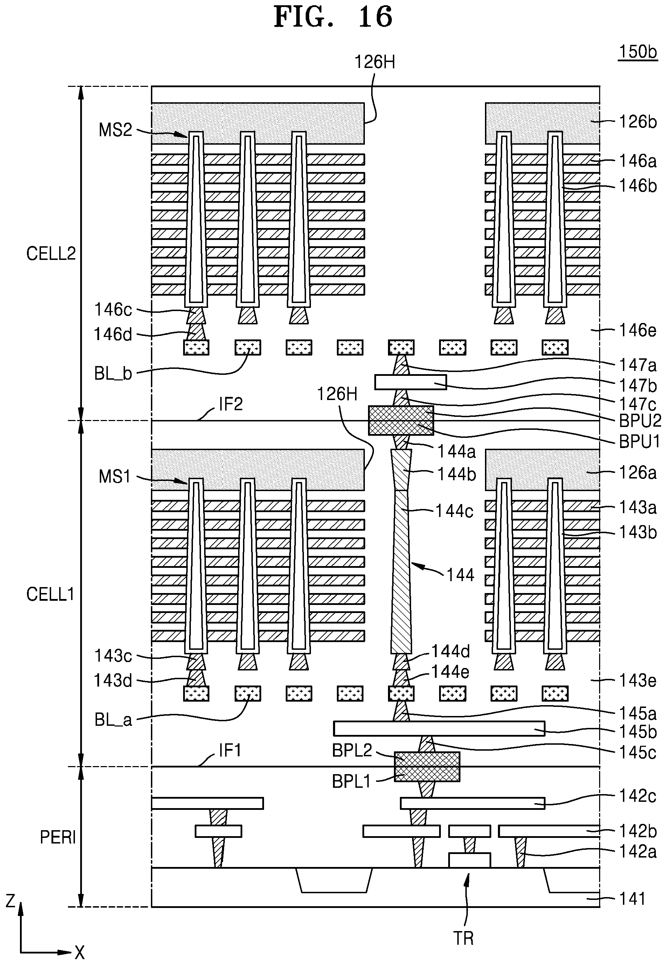

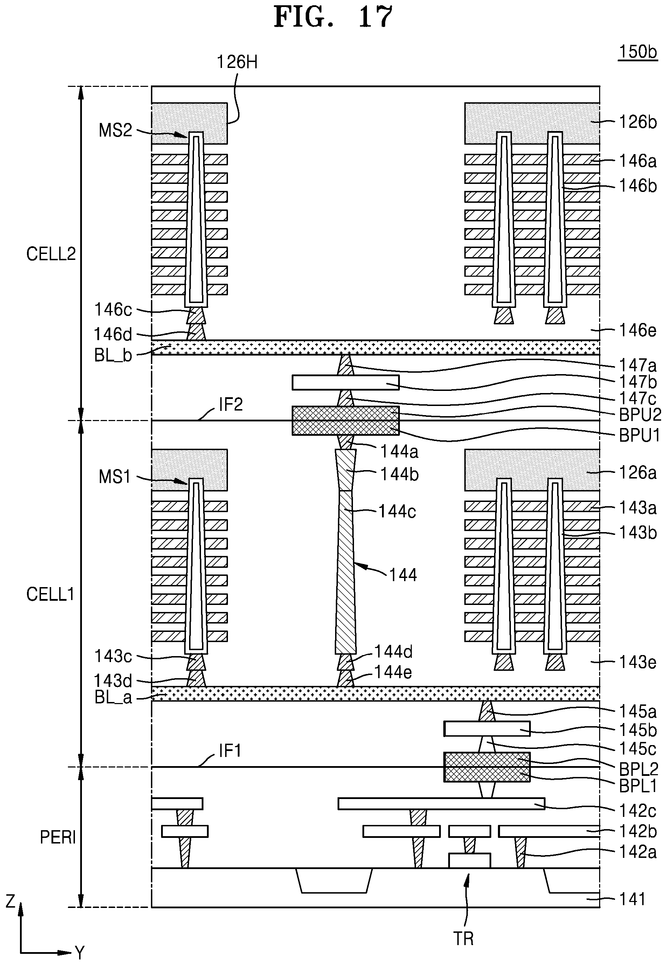

FIGS. 16 and 17 are cross-sectional views illustrating a memory device 150b according to an example embodiment. FIG. 16 is a schematic cross-sectional view taken along line A-A' of FIGS. 15A and 15B, and FIG. 17 is a schematic cross-sectional view taken along line B-B' of FIGS. 15A and 15B.

Referring to FIGS. 16 and 17, single pad type low-level bonding pads BPL1 and BPL2 may be provided at the first bonding interface IF1, and single pad type high-level bonding pads BPU1 and BPU2 may be provided at the second bonding interface IF2. The first via 145a, the wiring layer 145b, and the second via 145c may be sequentially located between the low-level bit line BL_a and the upper low-level bonding pad BPL2, and the connection via structure 144 may be located between the upper low-level bonding pad BPL2 and the high-level bonding pad BPU1. The first via 147a, the wiring layer 147b, and the second via 147c may be sequentially located between the high-level bit line BL_b and the upper high-level bonding pad BPU2.

According to an example embodiment, the first via 145a may correspond to the first to eighth low-level connection vias 122_1 to 122_8 described above with reference to FIGS. 13 and 14B. The upper low-level bonding pad BPL2 and the lower low-level bonding pad BPL1 may correspond to the first to eighth low-level bonding pads 132_1 to 132_8 described above with reference to FIG. 15B.

According to an example embodiment, the first via 147a may correspond to the first to eighth high-level connection vias 124_1 to 124_8 described above with reference to FIGS. 13 and 14A. The upper high-level bonding pad BPU2 and the lower high-level bonding pad BPU1 may correspond to the first to eighth high-level bonding pads 134_1 to 134_8 described above with reference to FIG. 15A.

In FIG. 17, the high-level first via 147a is offset or spaced apart from the low-level first via 145a in the second horizontal direction Y. This arrangement in FIG. 17 may correspond to the third to eighth high-level connection vias 124_3 to 124_8 (in FIG. 14A), which are offset or spaced apart from each other by the offset distances sd3 to sd8 from the low-level connection vias 122_3 to 122_8 in the second horizontal direction Y. Moreover, in FIG. 16, the upper high-level bonding pad BPU2 and the lower high-level bonding pad BPU1 are offset or spaced apart from the upper low-level bonding pad BPL2 and the lower low-level bonding pad BPL1 in the second horizontal direction Y. This arrangement in FIG. 17 may correspond to the fifth to eighth high-level bonding pads 134_5 to 134_8 (in FIG. 15A), which are offset or spaced apart by the offset distance sd11 from the fifth to eighth low-level bonding pads 132_5 to 132_8 in the second horizontal direction Y.

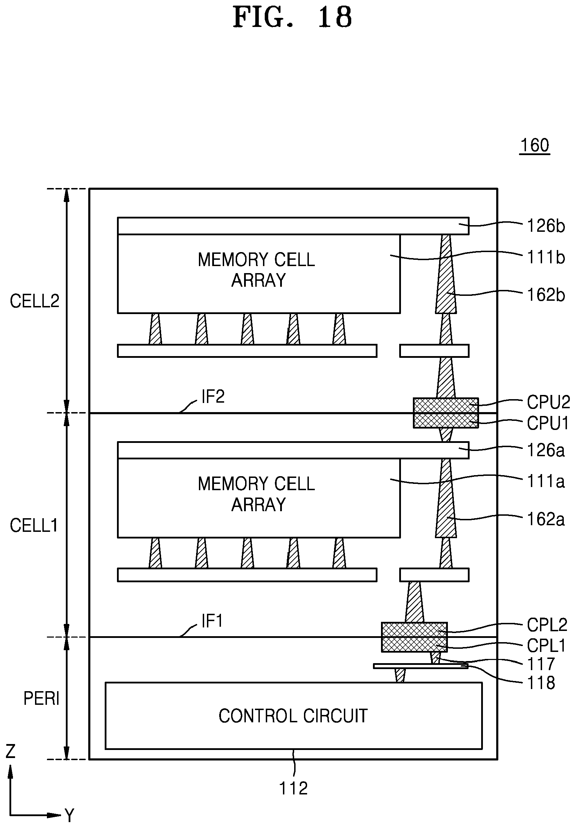

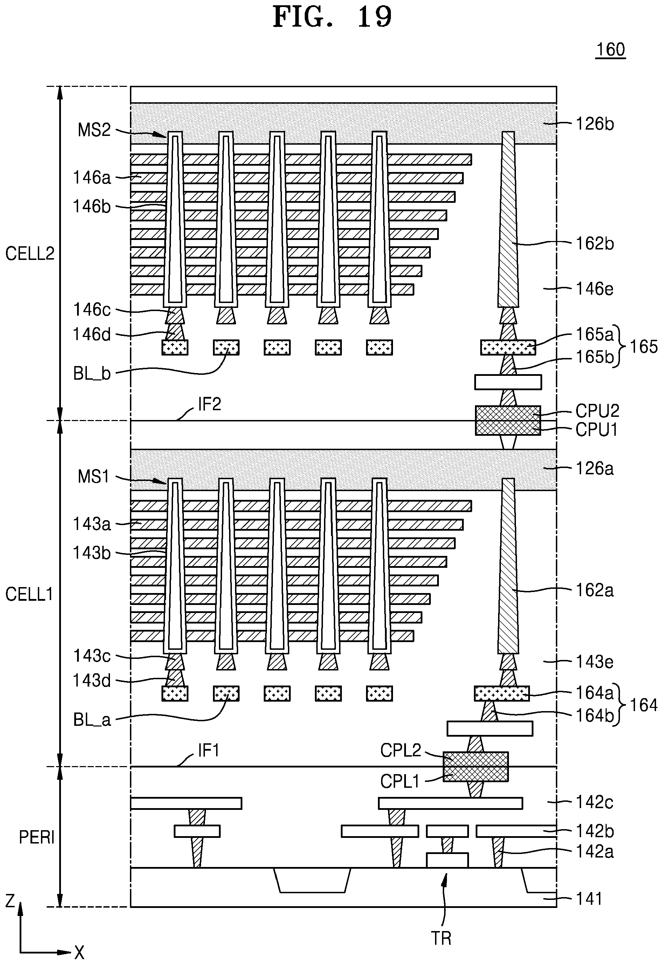

FIG. 18 is a diagram illustrating a memory device 160 according to an example embodiment. FIG. 19 is a schematic cross-sectional view of the memory device 160 of FIG. 18.

Referring to FIGS. 18 and 19, the memory device 160 may include a first vertical contact 162a extending in a vertical direction from one side of the first memory cell array 111a and connected to the first common source plate 126a and a second vertical contact 162b extending in the vertical direction from one side of the second memory cell array 111b and connected to the second common source plate 126b.

The first vertical contact 162a may be electrically connected to a circuit (e.g., transistor TR) in the peripheral circuit region PERI by low-level bonding pads CPL1 and CPL2 provided at the first bonding interface IF1, and the second vertical contact 162b may be electrically connected to the first common source plate 126a by high-level bonding pads CPU1 and CPU2 provided at the second bonding interface IF2. The high-level bonding pads CPU1 and CPU2 may be offset from the low-level bonding pads CPL1 and CPL2 in a lateral direction (e.g., in the first horizontal direction X or the second horizontal direction Y). The low-level bonding pads CPL1 and CPL2 and the high-level bonding pads CPU1 and CPU2 may be bonding structures for electrically connecting a common source line CSL connected to the first memory cell array 111a and a common source line CSL connected to the second memory cell array 111b to the transistor TR formed in the peripheral circuit region PERI. For example, the transistor TR formed in the peripheral circuit region PERI may include the control circuit 112.

According to an example embodiment, the low-level bonding pads CPL1 and CPL2 may be electrically connected to the first vertical contact 162a by a first connection structure 164, and the first connection structure 164 may include, for example, a wiring layer 164a and a via 164b. The wiring layer 164a may include at least two metal layers located at different vertical levels. For example, at least one wiring layer 164a may be provided at the same vertical level as that of the low-level bit line BL_a. Also, the first vertical contact 162a may be located to directly contact the first common source plate 126a in a position vertically overlapping the first common source plate 126a, and the high-level bonding pads CPU1 and CPU2 may be located on a second surface of the first common source plate 126a opposite to a first surface of the first common source plate 126a.

According to an example embodiment, the high-level bonding pads CPU1 and CPU2 may be electrically connected to the second vertical contact 162b by the second connection structure 165, and the second connection structure 165 may include, for example, a wiring layer 165a and a via 165b. The wiring layer 165a may include at least two metal layers provided on different vertical levels. For example, at least one wiring layer 165a may be located on the same vertical level as that of the high-level bit line BL_b.

According to the embodiments described above, as the high-level bonding pads CPU1 and CPU2 are laterally offset from the low-level bonding pads CPL1 and CPL2, a wiring connection between the peripheral circuit region PERI and the first cell region CELL1 may be optimized, and a wiring connection between the first and second cell regions CELL1 and CELL2 may be independently optimized, and thus, design flexibility of the memory device 160 may be improved.

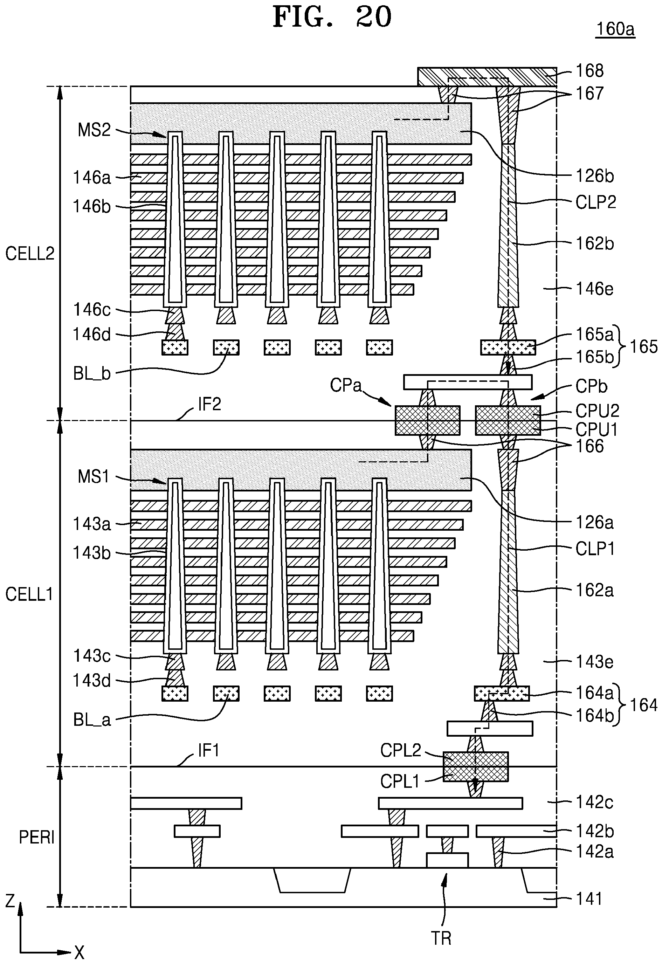

FIG. 20 is a cross-sectional view illustrating a memory device 160a according to an example embodiment.

Referring to FIG. 20, the first vertical contact 162a may be located outside the first common source plate 126a. For example, the first vertical contact 162a may be located in a position not overlapping the first common source plate 126a. The high-level bonding pads CPU1 and CPU2 may include a first bonding pad CPa and a second bonding pad CPb provided at the second bonding interface IF2, and the first bonding pad CPa may be electrically connected to the second bonding pad CPb by the wiring layer 165a and the via 165b of the second connection structure 165. The first bonding pad CPa may be located in a position vertically overlapping the first common source plate 126a, and the second bonding pad CPb may be located in a position vertically overlapping the first vertical contact 162a.

Instead of directly contacting the first common source plate 126a, the first vertical contact 162a may be connected to the high-level bonding pads CPU1 and CPU2, for example, the second bonding pad CPb, through the first connection via 166. As an electrical path CLP1 is indicated by the dashed line arrow in FIG. 20, the first vertical contact 162a may be electrically connected to the second bonding pad CPb through the first connection via 166 and may be electrically connected to the first common source plate 126a via the wiring layer 165a and the via 165b of the second connection structure 165 connected to the second bonding pad CPb and via the first bonding pad CPa and the first connection via 166. Accordingly, the electrical path CLP1 may be provided from the first common source plate 126a to the peripheral circuit TR through the low-level bonding pads CPL1 and CPL2 via the first bonding pad CPa, the wiring layer 165a of the second connection structure 165, the second bonding pad CPb, the first connection via 166, and the first vertical contact 162a.

The second vertical contact 162b may be electrically connected to a rear conductive layer 168 through the second connection via 167, instead of directly contacting the second common source plate 126b. As an electrical path CLP2 is indicated by the dashed line arrow in FIG. 20, the second vertical contact 162b may be electrically connected to the rear conductive layer 168 through the second connection via 167 provided in a position vertically overlapping the second vertical contact 162b, and the rear conductive layer 168 may be electrically connected to the second common source plate 126b via the second connection via 167 connected between the rear conductive layer 168 and the second common source plate 126b. Accordingly, the electrical path CLP2 may be provided from the second common source plate 126b to the high-level bonding pads CPU1 and CPU2 via the second connection via 167, the rear conductive layer 168, the second connection via 167, and the second vertical contact 162b.

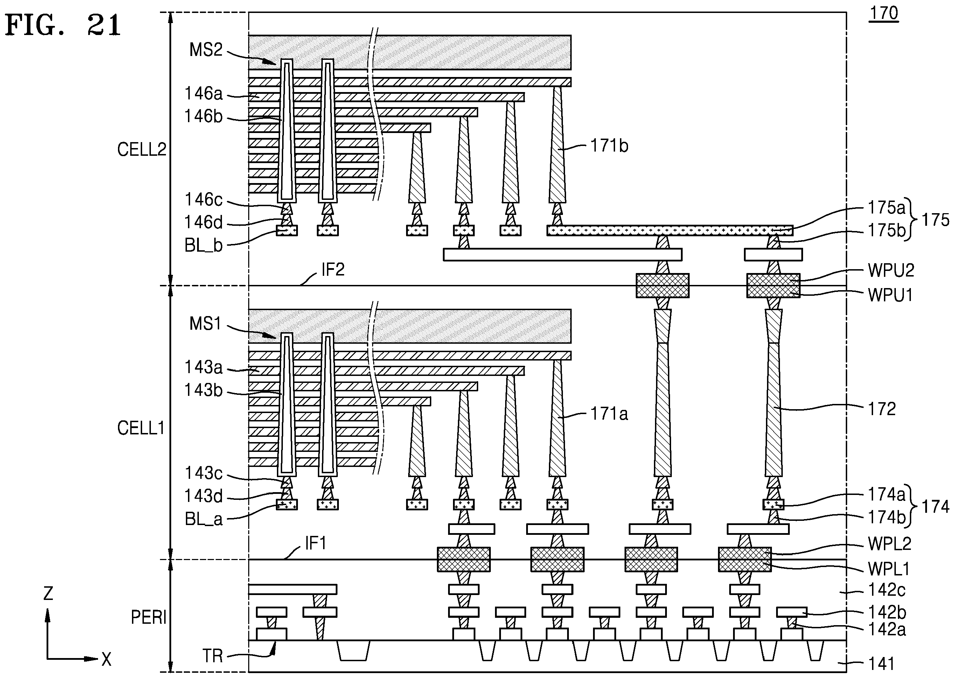

FIG. 21 is a cross-sectional view illustrating a memory device 170 according to an example embodiment.

Referring to FIG. 21, the memory device 170 may include cell contacts 171a connected to the word lines 143a in the first cell region CELL1 and cell contacts 171b connected to the word lines 146a in the second cell region CELL2. The cell contacts 171a may be located on pad portions, which are portion of the word lines 143a, e.g., pad portions formed in a step shape, and may be electrically connected to the word lines 143a, respectively. The cell contacts 171b may be located on pad portions, which are portion of the word lines 146a, e.g., pad portions formed in a step shape, and may be electrically connected to the word lines 146a, respectively.

The cell contact 171a included in the first cell region CELL1 may be electrically connected to the low-level bonding pads WPL1 and WPL2 provided at the first bonding interface IF1 via a first connection structure 174, and may be electrically connected to the transistor TR located in the peripheral circuit region PERI through the low-level bonding pads WPL1 and WPL2. For example, the transistor TR may include the row decoder of the control circuit 112 described above with reference to FIGS. 18 and 19. For example, the first connection structure 174 may include a wiring layer 174a and a via 174b. The wiring layer 174a may include at least two metal layers provided on different vertical levels.

The cell contact 171b included in the second cell region CELL2 may be electrically connected to the high-level bonding pads WPU1 and WPU2 provided at the second bonding interface IF2 via a second connection structure 175. The high-level bonding pads WPU1 and WPU2 may be electrically connected to the vertical contact 172, and may be electrically connected to the transistor TR located in the peripheral circuit region PERI via the vertical contact 172 and the low-level bonding pads WPL1 and WPL2. For example, the second connection structure 175 may include a wiring layer 175a and a via 175b. The wiring layer 175a may include at least two metal layers provided on different vertical levels.

According to an example embodiment, the high-level bonding pads WPU1 and WPU2 electrically connected to the cell contact 171b included in the second cell region CELL2 may be laterally offset or spaced apart from the low-level bonding pads WPL1 and WPL2 corresponding thereto.

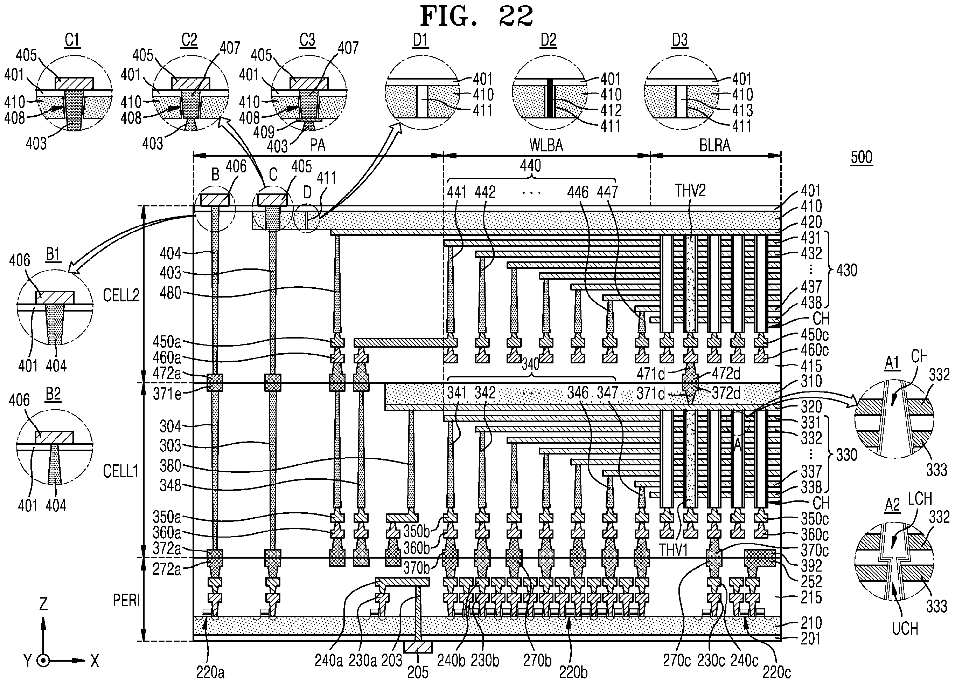

FIG. 22 is a diagram illustrating a memory device 500 according to an example embodiment.

Referring to FIG. 22, the memory device 500 may have a chip-to- chip (C2C) structure. Here, the C2C structure may refer to a structure in which at least one upper chip including the cell region CELL and a lower chip including the peripheral circuit region PERI are separately manufactured and then bonded to each other by a bonding method. For example, the bonding method may refer to a method of electrically or physically connecting a bonding metal pattern formed on the uppermost metal layer of the upper chip to a bonding metal pattern formed on the uppermost metal layer of the lower chip. For example, in an example in which the bonding metal patterns include copper (Cu), the bonding method may be a Cu-Cu bonding method. As another example, the bonding metal patterns may also include aluminum (Al) or tungsten (W).

The memory device 500 may include at least one upper chip including a cell region. For example, as shown in FIG. 22, the memory device 500 may be implemented to include two upper chips. However, this is an example, and the number of upper chips is not limited thereto. In an example in which the memory device 500 is implemented to include two upper chips, a first upper chip including the first cell region CELL1, a second upper chip including the second cell region CELL2, and a lower chip including the peripheral circuit region PERI may be separately manufactured and then connected to each other by a bonding method, thereby manufacturing the memory device 500. The first upper chip may be reversed and connected to the lower chip by a bonding method, and the second upper chip may also be reversed and connected to the first upper chip by a bonding method. In the following description, upper and lower portions of the first and second upper chips are defined based on before the first upper chip and the second upper chip are reversed. That is, in FIG. 22, the upper portion of the lower chip refers to an upper portion defined based on the +Z-axis direction, and the upper portion of each of the first and second upper chips refers to an upper portion defined based on the -Z-axis direction. However, this is an example, and only one of the first upper chip and the second upper chip may be reversed and connected by a bonding method.

The peripheral circuit region PERI and each of the first and second cell regions CELL1 and CELL2 of the memory device 500 may include an external pad bonding region PA, a word line bonding region WLBA, and a bit line bonding region BLBA.

The peripheral circuit region PERI may include a first substrate 210 and a plurality of circuit elements 220a, 220b, and 220c formed on the first substrate 210. An interlayer insulating layer 215 including one or more insulating layers may be provided on the circuit elements 220a, 220b, and 220c, and a plurality of metal wirings connecting the circuit elements 220a, 220b, and 220c may be provided in the interlayer insulating layer 215. For example, the metal wirings may include first metal wirings 230a, 230b, and 230c respectively connected to the circuit elements 220a, 220b, and 220c and second metal wirings 240a, 240b, and 240c respectively formed on the first metal wirings 230a, 230b, and 230c. The metal wirings may include at least one of various conductive materials. For example, the first metal wirings 230a, 230b, and 230c may include tungsten having a relatively high electrical resistivity, and the second metal wirings 240a, 240b, and 240c may include copper having a relatively low electrical resistivity.

According to an example embodiment of the disclosure, only the first metal wirings 230a, 230b, and 230c and the second metal wirings 240a, 240b, and 240c are shown and described, but the disclosure is not limited thereto. As such, according to another embodiment, at least one additional metal wiring may be further formed on the second metal wirings 240a, 240b, and 240c. In this case, the second metal wirings 240a, 240b, and 240c may include aluminum. In addition, at least some of the additional metal wirings formed on the second metal wirings 240a, 240b, and 240c may include copper having a lower electrical resistivity than that of aluminum of the second metal wirings 240a, 240b, and 240c.

The interlayer insulating layer 215 may be provided on the first substrate 210 and may include an insulating material, such as silicon oxide or silicon nitride.

Each of the first and second cell regions CELL1 and CELL2 may include at least one memory block. The first cell region CELL1 may include a second substrate 310 and a common source line 320. A plurality of word lines 331 to 338 (together referred to as plurality of word lines 330) may be stacked on the second substrate 310 in a direction (a Z-axis direction) perpendicular to an upper surface of the second substrate 310. String select lines and a ground select line may be located above and below the word lines 330, and a plurality of word lines 330 may be located between the string select lines and the ground select line. Similarly, the second cell region CELL2 may include a third substrate 410 and a common source line 420, and a plurality of word lines 431 to 438 (together referred to as plurality of word lines 430) may be stacked on the third substrate 410 in a direction (the Z-axis direction) perpendicular to an upper surface of the third substrate 410. The second substrate 310 and the third substrate 410 may include various materials and may include, for example, a silicon substrate, a silicon-germanium substrate, a germanium substrate, or a substrate having a single crystal epitaxial layer grown on a monocrystalline silicon substrate. A plurality of channel structures CH may be formed in each of the first and second cell regions CELL1 and CELL2.

In an example embodiment, as shown in A1, the channel structure CH may be provided in a bit line bonding region BLBA and extend in a direction perpendicular to the upper surface of the second substrate 310 to pass through the word lines 330, string select lines, and the ground select line. The channel structure CH may include a data storage layer, a channel layer, and a buried insulating layer. The channel layer may be electrically connected to a first metal wiring 350c and a second metal wiring 360c in the bit line bonding region BLBA. For example, the second metal wiring 360c may be a bit line and may be connected to the channel structure CH through the first metal wiring 350c. The bit line 360c may extend in the first direction (a Y-axis direction) parallel to the upper surface of the second substrate 310.

In an example embodiment, as shown in A2, the channel structure CH may include a lower channel LCH and an upper channel UCH connected to the lower channel LCH. For example, the channel structure CH may be formed through a process for the lower channel LCH and a process for the upper channel UCH. The lower channel LCH may extend in a direction perpendicular to the upper surface of the second substrate 310 and pass through the common source line 320 and the lower word lines 331 and 332. The lower channel LCH may include a data storage layer, a channel layer, and a buried insulating layer, and may be connected to the upper channel UCH. The upper channel UCH may pass through the upper word lines 333 to 338. The upper channel UCH may include a data storage layer, a channel layer, and a buried insulating layer, and the channel layer of the upper channel UCH may be electrically connected to the first metal wiring 350c and the second metal wiring 360c. As a length of a channel increases, it may be difficult to form a channel having a constant width due to process reasons. The memory device 500 according to an example embodiment may include a channel having improved width uniformity through the lower channel LCH and the upper channel UCH formed through a sequential process.

As shown in A2, in an example in which the channel structure CH is formed to include the lower channel LCH and the upper channel UCH, a word line located near a boundary of the lower channel LCH and the upper channel UCH may be a dummy word line. For example, the word line 332 and word line 333 forming a boundary between the lower channel LCH and the upper channel UCH may be dummy word lines. In this case, data may not be stored in memory cells connected to the dummy word lines. Alternatively, the number of pages corresponding to the memory cells connected to the dummy word lines may be less than the number of pages corresponding to memory cells connected to general word lines. A voltage level applied to the dummy word line may be different from a voltage level applied to the general word line, and thus, an effect of non-uniform channel widths of the lower channel LCH and the upper channel UCH on the operation of the memory device 500 may be reduced.

Meanwhile, in A2, it is illustrated that the number of lower word lines 331 and 332 through which the lower channel LCH passes is less than the number of upper word lines 333 to 338 through which the upper channel UCH passes. However, this is an example, and the disclosure is not limited thereto. As another example, the number of lower word lines passing through the lower channel LCH may be equal to or greater than the number of upper word lines passing through the upper channel UCH. In addition, a structure and connection relationship of the channel structure CH located in the first cell region CELL1 described above may be equally applied to the channel structure CH located in the second cell region CELL2.

In the bit line bonding region BLBA, a first through-electrode THV1 may be provided in the first cell region CELL1, and a second through-electrode THV2 may be provided in the second cell region CELL2. As shown in FIG. 22, the first through-electrode THV1 may pass through the common source line 320 and the word lines 330. However, this is an example, and the first through-electrode THV1 may further pass through the second substrate 310. The first through-electrode THV1 may include a conductive material. Alternatively, the first through-electrode THV1 may include a conductive material surrounded by an insulating material. The second through-electrode THV2 may also be provided in the same shape and structure as that of the first through-electrode THV1.

In an example embodiment, the first through-electrode THV1 may be electrically connected to the second through-electrode THV2 through a first through-metal pattern 372d and a second through-metal pattern 472d. The first through-metal pattern 372d may be formed at a lower end of the first upper chip including the first cell region CELL1, and the second through-metal pattern 472d may be formed at an upper end of the second upper chip including the second cell region CELL2. The first through-electrode THV1 may be electrically connected to the first metal wiring 350c and the second metal wiring 360c. A lower via 371d may be formed between the first through-electrode THV1 and the first through-metal pattern 372d, and an upper via 471d may be formed between the second through-electrode THV2 and the second through-metal pattern 472d. The first through-metal pattern 372d may be connected to the second through-metal pattern 472d by a bonding method.

In addition, in the bit line bonding region BLBA, an upper metal pattern 252 may be formed on the uppermost metal layer of the peripheral circuit region PERI, and an upper metal pattern 392 having the same shape as that of the upper metal pattern 252 may be formed on the uppermost metal layer of the first cell region CELL1. The upper metal pattern 392 of the first cell region CELL1 may be electrically connected to the upper metal pattern 252 of the peripheral circuit region PERI by a bonding method. In the bit line bonding region BLBA, the bit line 360c may be electrically connected to a page buffer included in the peripheral circuit region PERI. For example, some of the circuit elements 220c of the peripheral circuit region PERI may provide a page buffer, and the bit line 360c may be electrically connected to the circuit elements 220c providing the page buffer through the upper bonding metal 370c of the first cell region CELL1 and the upper bonding metal 270c of the peripheral circuit region PERI.

Subsequently, referring to FIG. 22, in the word line bonding region WLBA, the word lines 330 of the first cell region CELL1 may extend in a second direction (an X-axis) parallel to the upper surface of the second substrate 310 and may be connected to the cell contact plugs 341 to 347: 340. A first metal wiring 350b and a second metal wiring 360b may be sequentially connected to upper portions of the cell contact plugs 340 connected to the word lines 330. In the word line bonding region WLBA, the cell contact plugs 340 may be connected to the peripheral circuit region PERI through the upper bonding metal 370b of the first cell region CELL1 and the upper bonding metal 270b of the peripheral circuit region PERI.

The cell contact plugs 340 may be electrically connected to a row decoder included in the peripheral circuit region PERI. For example, some of the circuit elements 220b of the peripheral circuit region PERI may provide a row decoder, and the cell contact plugs 340 may be electrically connected to the circuit elements 220b providing the row decoder through the upper bonding metal 370b of the first cell region CELL1 and the upper bonding metal 270b of the peripheral circuit region PERI. In an example embodiment, an operating voltage of the circuit elements 220b providing the row decoder may be different from an operating voltage of the circuit elements 220c providing the page buffer. For example, the operating voltage of the circuit elements 220c providing the page buffer may be higher than the operating voltage of circuit elements 220b providing the row decoder.

Similarly, in the word line bonding region WLBA, the word lines 430 of the second cell region CELL2 may extend in the second direction (the X-axis direction) parallel to the upper surface of the third substrate 410 and may be connected to the cell contact plugs 441 to 447:440. The cell contact plugs 440 may be connected to the peripheral circuit region PERI through the upper metal pattern of the second cell region CELL2, the lower metal pattern and the upper metal pattern of the first cell region CELL1, and the cell contact plug 348.

In the word line bonding region WLBA, the upper bonding metal 370b may be formed in the first cell region CELL1 and the upper bonding metal 270b may be formed in the peripheral circuit region PERI. The upper bonding metal 370b of the first cell region CELL1 may be electrically connected to the upper bonding metal 270b of the peripheral circuit region PERI by a bonding method. The upper bonding metal 370b and the upper bonding metal 270b may include aluminum, copper, or tungsten.

In the external pad bonding region PA, a lower metal pattern 371e may be formed in a lower portion of the first cell region CELL1 and an upper metal pattern 472a may be formed in an upper portion of the second cell region CELL2. The lower metal pattern 371e of the first cell region CELL1 and the upper metal pattern 472a of the second cell region CELL2 may be connected by a bonding method in the external pad bonding region PA. Similarly, an upper metal pattern 372a may be formed in an upper portion of the first cell region CELL1, and an upper metal pattern 272a may be formed in an upper portion of the peripheral circuit region PERI. The upper metal pattern 372a of the first cell region CELL1 may be connected to the upper metal pattern 272a of the peripheral circuit region PERI by a bonding method.

Common source line contact plugs 380 and 480 may be located in the external pad bonding region PA. The common source line contact plugs 380 and 480 may include a conductive material, such as metal, a metal compound, or doped polysilicon. The common source line contact plug 380 of the first cell region CELL1 may be electrically connected to the common source line 320, and the common source line contact plug 480 of the second cell region CELL2 may be electrically connected to the common source line 420. A first metal wiring 350a and a second metal wiring 360a may be sequentially stacked on the common source line contact plug 380 of the first cell region CELL1, and a first metal wiring 450a and a second metal wiring 460a may be sequentially stacked on the common source line contact plug 480 of the second cell region CELL2.

First, second, and third I/O pads 205, 405, and 406 may be located in the external pad bonding region PA. Referring to FIG. 22, a lower insulating film 201 may cover a lower surface of the first substrate 210, and the first I/O pad 205 may be formed on the lower insulating film 201. The first I/O pad 205 may be connected to at least one of the circuit elements 220a arranged in the peripheral circuit region PERI through the first I/O contact plug 203, and may be separated from the first substrate 210 by the lower insulating film 201. In addition, a side insulating film may be located between the first I/O contact plug 203 and the first substrate 210 to electrically separate the first I/O contact plug 203 from the first substrate 210.

An upper insulating film 401 covering an upper surface of the third substrate 410 may be formed on the third substrate 410. The second I/O pad 405 and/or the third I/O pad 406 may be provided on the upper insulating film 401. The second I/O pad 405 may be connected to at least one of the circuit elements 220a arranged in the peripheral circuit region PERI through second I/O contact plugs 403 and 303, and the third I/O pad 406 may be connected to at least one of the circuit elements 220a located in the peripheral circuit region PERI through third I/O contact plugs 404 and 304.

In an example embodiment, the third substrate 410 may not be located in a region in which the I/O contact plugs are provided. For example, as shown in B1, the third I/O contact plug 404 may be separated from the third substrate 410 in a direction parallel to the upper surface of the third substrate 410, and may be connected to the third I/O pad 406 through the interlayer insulating layer 415 of the second cell region CELL2. In this case, the third I/O contact plug 404 may be formed through various processes.

As an example, as shown in B1, the third I/O contact plug 404 may extend in the third direction (the Z-axis direction) and may have a larger diameter toward the upper insulating film 401. That is, while a diameter of the channel structure CH described in A1 may decrease toward the upper insulating film 401, the diameter of the third I/O contact plug 404 may increase toward the upper insulating film 401. For example, the third I/O contact plug 404 may be formed after the second cell region CELL2 is bonded to the first cell region CELL1.

Also, as an example, as shown in B2, the third I/O contact plug 404 may extend in the third direction (the Z-axis direction) and have a diameter decreasing toward the upper insulating film 401. That is, the diameter of the third I/O contact plug 404 may decrease toward the upper insulating film 401, like the channel structure CH. For example, the third I/O contact plug 404 may be formed together with the cell contact plugs 440 before the second cell region CELL2 is bonded to the first cell region CELL1.

In another embodiment, the I/O contact plugs may be located to overlap the third substrate 410. For example, as shown in C1, the second I/O contact plug 403 may be formed to pass through the interlayer insulating layer 415 of the second cell region CELL2 in the third direction (the Z-axis direction) and may be electrically connected to the second I/O pad 405 through the third substrate 410. In this case, a connection structure of the second I/O contact plug 403 and the second I/O pad 405 may be implemented in various manners.

As an example, as shown in C1, an opening 408 may be formed through the third substrate 410, and the second I/O contact plug 403 may be directly connected to the second I/O pad 405 through the opening 408 formed in the third substrate 410. In this case, as shown in C1, a diameter of the second I/O contact plug 403 may increase toward the second I/O pad 405. However, this is an example, and the diameter of the second I/O contact plug 403 may decrease toward the second I/O pad 405.

As an example, as shown in C2, the opening 408 may be formed through the third substrate 410, and a contact 407 may be formed in the opening 408. One end of the contact 407 may be connected to the second I/O pad 405 and the other end thereof may be connected to the second I/O contact plug 403. Accordingly, the second I/O contact plug 403 may be electrically connected to the second I/O pad 405 through the contact 407 in the opening 408. In this case, as shown in C2, a diameter of the contact 407 may increase toward the second I/O pad 405, and a diameter of the second I/O contact plug 403 may decrease toward the second I/O pad 405. For example, the second I/O contact plug 403 may be formed together with the cell contact plugs 440 before the second cell region CELL2 is bonded to the first cell region CELL1, and the contact 407 may be formed after the second cell region CELL2 is bonded to the first cell region CELL1.

Also, as an example, as shown in C3, a stopper 409 may be further formed on an upper surface of the opening 408 of the third substrate 410, compared to C2. The stopper 409 may be a metal wiring formed on the same layer as that of the common source line 420. However, this is an example, and the stopper 409 may be a metal wiring formed on the same layer as that of at least one of the word lines 430. The second I/O contact plug 403 may be electrically connected to the second I/O pad 405 through the contact 407 and the stopper 409.

Meanwhile, similar to the second and third I/O contact plugs 403 and 404 of the second cell region CELL2, the second and third I/O contact plugs 303 and 304 of the first cell region CELL1 may each have a diameter decreasing or increasing toward the lower metal pattern 371e.

Meanwhile, according to an example embodiment, a slit 411 may be formed in the third substrate 410. For example, the slit 411 may be formed in a certain position of the external pad bonding region PA. For example, as shown in D1, the slit 411 may be located between the second I/O pad 405 and the cell contact plugs 440 in a plan view. However, this is an example, and the slit 411 may be formed such that the second I/O pad 405 is located between the slit 411 and the cell contact plugs 440 in a plan view.

As an example, as shown in D1, the slit 411 may be formed to pass through the third substrate 410. The slit 411 may be used, for example, to prevent the third substrate 410 from being minutely cracked when the opening 408 is formed. However, this is an example, and the slit 411 may be formed to have a depth of about 60 % to 70 % of a thickness of the third substrate 410.

Also, as an example, as shown in D2, a conductive material 412 may be formed in the slit 411. The conductive material 412 may be used, for example, to discharge current leakage occurring during driving of the circuit elements within the external pad bonding region PA to the outside. In this case, the conductive material 412 may be connected to an external ground line.

Also, as an example, as shown in D3, an insulating material 413 may be formed in the slit 411. The insulating material 413 may be formed to, for example, electrically separate the second I/O pad 405 and the second I/O contact plug 403 located in the external pad bonding region PA from the word line bonding region WLBA. By forming the insulating material 413 in the slit 411, a voltage provided through the second I/O pad 405 may be prevented from affecting on the metal layer provided on the third substrate 410 in the word line bonding region WLBA.

Meanwhile, according to an example embodiment, the first to third I/O pads 205, 405, and 406 may be selectively formed. For example, the memory device 500 may include only the first I/O pad 205 provided on the first substrate 210, only the second I/O pad 405 provided on the third substrate 410, or only the third I/O pad 406 provided on the upper insulating film 401.

Meanwhile, according to an example embodiment, at least one of the second substrate 310 of the first cell region CELL1 and the third substrate 410 of the second cell region CELL2 may be used as a sacrificial substrate, and may be completely or partially removed before or after a bonding process. An additional film may be stacked after substrate removal. For example, the second substrate 310 of the first cell region CELL1 may be removed before or after bonding of the peripheral circuit region PERI and the first cell region CELL1, and an insulating film covering the upper surface of the common source line 320 or a conductive film for connection may be formed. Similarly, the third substrate 410 of the second cell region CELL2 may be removed before or after bonding of the first cell region CELL1 and the second cell region CELL2, and an upper insulating film 401 covering an upper surface of the common source line 420 or a conductive film for connection may be formed.

While the disclosure has been particularly shown and described above with reference to embodiments thereof, it will be understood that various changes in form and details may be made therein without departing from the spirit and scope of the following claims.

## Claims

1. A memory device comprising:
a first cell region comprising a plurality of first memory strings connected to each other in a vertical direction;
a second cell region coupled to the first cell region and comprising a plurality of second memory strings connected to each other in the vertical direction; and
a peripheral circuit region coupled to the first cell region and comprising a peripheral circuit configured to control the plurality of first memory strings and the plurality of second memory strings,
wherein the first cell region comprises:
a first bit line electrically connected to one or more of the plurality of first memory strings;
a first bonding pad provided at a first bonding interface between the peripheral circuit region and the first cell region;
a first connection via connected between the first bit line and the first bonding pad; and
a second bonding pad provided at a second bonding interface between the first cell region and the second cell region, and
the second cell region comprises:
a second bit line electrically connected to one or more of the plurality of second memory strings; and
a second connection via connected between the second bit line and the second bonding pad,
wherein the second connection via is offset with respect to the first connection via in a first horizontal direction, and
wherein the first bit line and the second bit line are electrically connected to the peripheral circuit through the first connection via, the first bonding pad, the second connection via, and the second bonding pad.

2. The memory device of claim 1, wherein the second connection via is spaced apart from the first connection via in the first horizontal direction, and
wherein the first bit line and the second bit line extend in the first horizontal direction.

3. The memory device of claim 1 or 2, wherein the first cell region comprises a connection via structure between the first bit line and the second bonding pad,
wherein the connection via structure overlaps the second bonding pad in the vertical direction.

4. The memory device of claim 3, wherein
the connection via structure comprises:
a first via directly contacting the first bit line;
a second via connected to the first via, the second via overlapping the first via in the vertical direction; and
a third via connected to the second via, the third via overlapping the second via in the vertical direction.

5. The memory device of claim 1, wherein
the first cell region comprises:
a connection via structure between the first bit line and the second bonding pad, and
a first common source plate electrically connected to the plurality of first memory strings,
wherein the connection via structure overlaps the second bonding pad in the vertical direction, and
wherein the first common source plate comprises an opening, and the connection via structure extends in the vertical direction in the opening.

6. The memory device of claim 5, wherein a sidewall of the opening of the first common source plate is offset from the connection via structure in a second horizontal direction intersecting the first horizontal direction.

7. The memory device of claim 5 or 6, wherein the connection via structure overlaps the opening of the first common source plate in the vertical direction.

8. The memory device of any one of claims 1 to 7, wherein
the first bit line and the second bit line extend in the first horizontal direction,
the first connection via comprises a plurality of first connection vias arranged in the first horizontal direction,
the second connection via comprises a plurality of second connection vias arranged in the first horizontal direction, and
a first planar arrangement shape of the plurality of first connection vias is different from a second planar arrangement shape of the second connection via.

9. The memory device of any one of claims 1 to 8, wherein the second bonding pad is spaced apart from the first bonding pad in the first horizontal direction.

10. The memory device of claim 1, wherein:
the first bit line is a first-level bit line, the first-level bit line extending in the first horizontal direction,
the first bonding pad is a first-level bonding pad,
the second bonding pad is a second-level bonding pad,
the first connection via is a first-level connection via located between the first-level bit line and the first-level bonding pad,
the first cell region comprises a connection via structure located between the first-level bit line and the second-level bonding pad, the connection via structure extending in the vertical direction and overlapping the second-level bonding pad in the vertical direction,
the second bit line is a second-level bit line, the second-level bit line extending in the first horizontal direction,
the second connection via is a second-level connection via located between the second-level bit line and the second-level bonding pad, and
the first-level bit line and the second-level bit line are electrically connected to the peripheral circuit through the first-level bonding pad, the first-level connection via, the connection via structure, the second-level bonding pad, and the second-level connection via.

11. The memory device of claim 10, wherein
the first-level connection via comprises a plurality of first-level connection vias,
the second-level connection via comprises a plurality of second-level connection vias, and
a first planar arrangement shape of the plurality of first-level connection vias is different from a second planar arrangement shape of the plurality of second-level connection vias.

12. The memory device of claim 11, wherein
the first-level bit line comprises a first first-level bit line and a second first-level bit line,
the plurality of first-level connection vias comprise a first first-level connection via connected to the first first-level bit line and a second first-level connection via connected to the second first-level bit line,
the second-level bit line comprises a first second-level bit line and a second second-level bit line,
the plurality of second-level connection vias comprise a first second-level connection via connected to the first second-level bit line and a second second-level connection via connected to the second second-level bit line,
the first second-level connection via spaced apart from the first first-level connection via in the first horizontal direction and electrically connected to the first first-level connection via, and
the second second-level connection via overlaps the second first-level connection via in the vertical direction and is electrically connected to the second first-level connection via.

13. The memory device of any one of claims 10 to 12, wherein
the first-level bonding pad comprises a plurality of first-level bonding pads,
the second-level bonding pad comprises a plurality of second-level bonding pads, and
a first planar arrangement shape of the plurality of first-level bonding pads is different from a second planar arrangement shape of the plurality of second-level bonding pads.

14. The memory device of claim 13, wherein
the first-level bit line comprises a first first-level bit line and a second first-level bit line,
the plurality of first-level bonding pads comprise a first first-level bonding pad connected to the first first-level bit line and a second first-level bonding pad connected to the second first-level bit line,
the second-level bit line comprises a first second-level bit line and a second second-level bit line,
the plurality of second-level bonding pads comprise a first second-level bonding pad connected to the first second-level bit line and a second second-level bonding pad connected to the second second-level bit line,
the first second-level bonding pad is spaced apart from the first first-level bonding pad in the first horizontal direction and electrically connected to the first first-level bonding pad, and
the second second-level bonding pad overlaps the second first-level bonding pad in the vertical direction and is electrically connected to the second first-level bonding pad.

15. A memory device comprising:
a first cell region comprising a plurality of first memory strings connected to each other in a vertical direction;
a second cell region coupled to the first cell region and comprising a plurality of second memory strings connected to each other in the vertical direction; and
a peripheral circuit region coupled to the first cell region and comprising a peripheral circuit configured to control the plurality of first memory strings and the plurality of second memory strings,
wherein the first cell region comprises:
a first-level bit line electrically connected to one or more of the plurality of first memory strings;
a plurality of first-level bonding pads provided at a first bonding interface between the peripheral circuit region and the first cell region; and
a plurality of second-level bonding pads provided at a second bonding interface between the first cell region and the second cell region,
wherein the plurality of second-level bonding pads are offset with respect to the plurality of first-level bonding pads in a first horizontal direction, and
wherein the second cell region comprises a second-level bit line electrically connected to one or more of the plurality of second memory strings and electrically connected to the plurality of second-level bonding pads, and
wherein a first planar arrangement shape of the plurality of first-level bonding pads is different from a second planar arrangement shape of the plurality of second-level bonding pads.
